# EUROPEAN PATENT SPECIFICATION

(11) **EP 0 657 863 B1**
(45) Date of publication and mention of the grant of the patent: **16.07.2003**
(21) Application number: 94302380.4
(22) Date of filing: 05.04.1994
(51) Int. Cl.: H03K 5/24, H03F 3/00

(54) **A signal amplifier circuit and an image display device adopting the signal amplifier circuit**
Signalverstärkerschaltung und Bildanzeigevorrichtung die einen Signalverstärkerschaltung verwendet
Circuit d'amplificateur de signal et dispositif d'affichage utilisant le circuit d'amplificateur de signal

(30) Priority: 09.12.1993 JP 30951793
(43) Date of publication of application: 14.06.1995
(73) Proprietor: SHARP KABUSHIKI KAISHA, Osaka-shi, Osaka-fu 545-0013 (JP)
(72) Inventor: Kubota, Yasushi, Nara 633 (JP); Katoh, Ken-ichi, Tenri-shi, Nara 632 (JP); Yoneda, Hiroshi, Nara 630-02 (JP)
(74) Representative: Suckling, Andrew Michael

(56) References cited:
- EP-A- 0 323 260
- EP-A- 0 391 654
- EP-A- 0 416 550
- EP-A- 0 565 167
- GB-A- 2 095 946
- JP-A- 4 012 591
- US-A- 5 006 739
- US-A- 5 192 945
- P. E. ALLEN, D. R. HOLBERG: "CMOS Analog Circuit Design" 1987 , HOLT RINEHART & WINSTON , NEW YORK XP002009395 * page 504, paragraph 9.7 - page 512; figures 9.7-6 *
- Y. TSIVIDIS & P. ANTOGNETTI, EDITORS: "DESIGN OF MOS VLSI CIRCUITS" 1989 , PRENTICE-HALL, INC. , NEW JERSEY XP002009396 * page 166, paragraph 5 - page 168; figure 5.1 *

## Description

### FIELD OF THE INVENTION

The present invention relates to a signal amplifier circuit and an image display device such as a liquid crystal display, etc., adopting the signal amplifier circuit.

### BACKGROUND OF THE INVENTION

A buffer amplifier has characteristics of high input impedance and low output impedance and of a voltage gain of substantially 1. Having the above characteristics, the buffer amplifier is used in a variety of fields.

The following descriptions will discuss the buffer amplifier through an example of an image display device of an active-matrix drive system provided with the buffer amplifier.

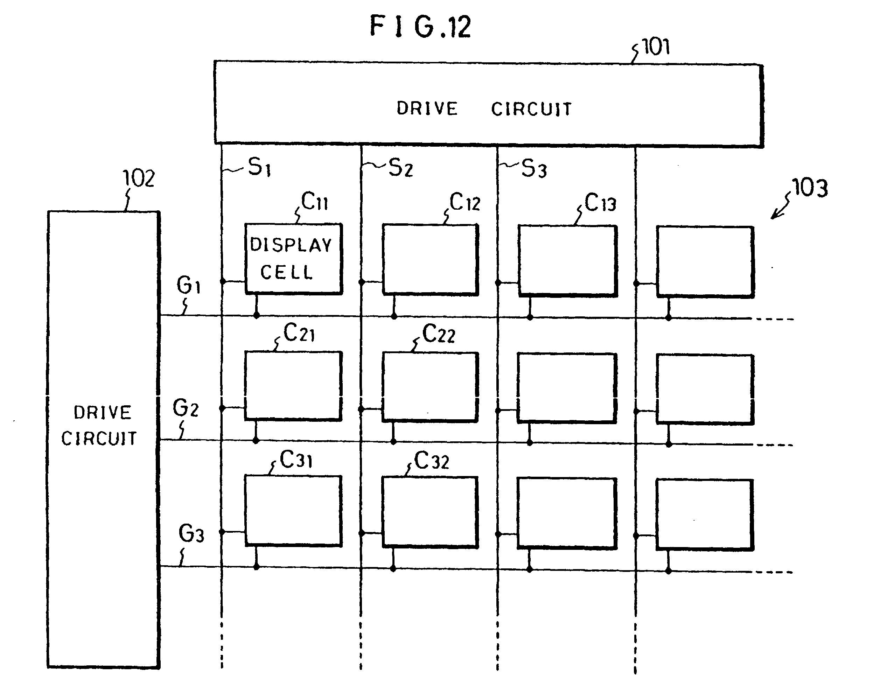

As shown in Fig. 12, the image display device of the active-matrix drive system is composed of drive circuits 101 and 102 and a display 103.

The display 103 is composed of display cells Cᵢⱼ arranged so as to form a matrix. The drive circuit 101 samples a video signal so as to send an obtained voltage by sampling as data over a data signal line Sⱼ. The drive circuit 102 selects a scanning signal line Gᵢ in order so as to send data on the data signal line Sj to a display cell Cᵢⱼ.

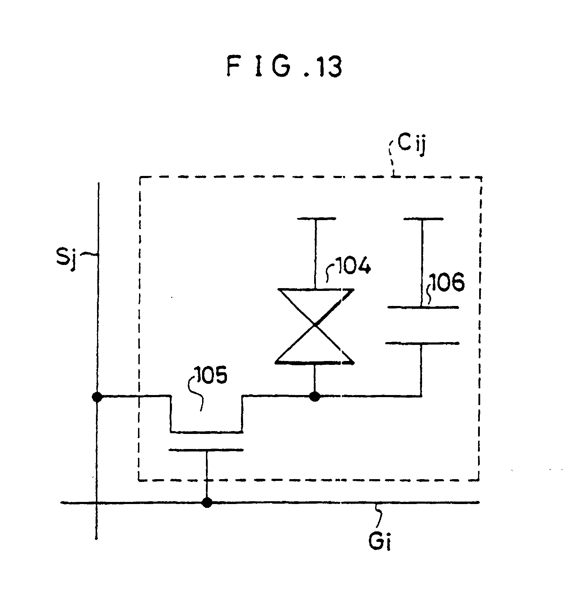

As shown in Fig. 13, in the case of liquid crystal displays, each display cell Cᵢⱼ is composed of a liquid crystal element 104 and a FET 105 (field effect transistor) for driving the liquid crystal element 104. Additionally, a condenser 106 may be provided in the display cell Cᵢⱼ if necessary.

A gate of the FET 105 is connected to the scanning signal line Gᵢ, and a drain and a source of the FET 105 are respectively connected to the data signal line Sⱼ and an electrode of the liquid crystal element 104. The other electrode of the liquid crystal element 104 is connected to a line used in common for all the display cells Cᵢⱼ. As a result, a transmittance or a reflectance of a liquid crystal of the liquid crystal element 104 are adjusted based on data. In the described manner, an image corresponding to a video signal is displayed on the display 103 composed of display cells Cᵢⱼ.

A drive circuit 101 is classified into two kinds: a digital driver for outputting digital data to the data signal line Sj; and an analog driver for outputting analog data to the data signal line Sⱼ.

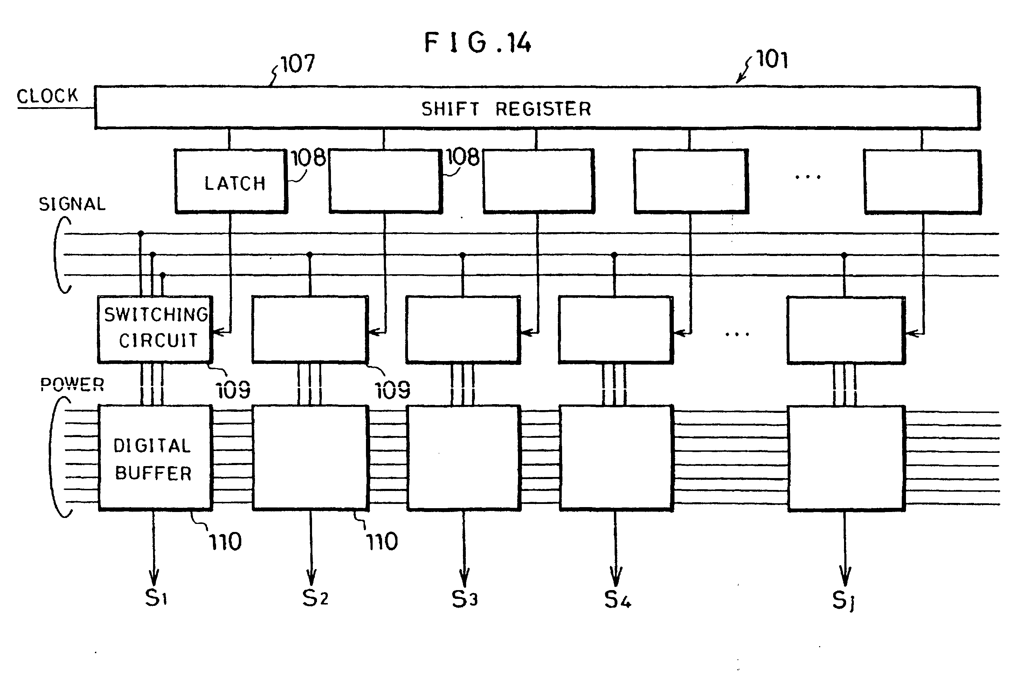

As an example of digital drivers, a digital driver for a 3 bits-input, i.e., an 8 gradation (= 2³) display is shown in Fig. 14.

The digital driver is composed of a shift register 107, a plurality of latches 108, a plurality of switching circuits 109 and a plurality of digital buffers 110.

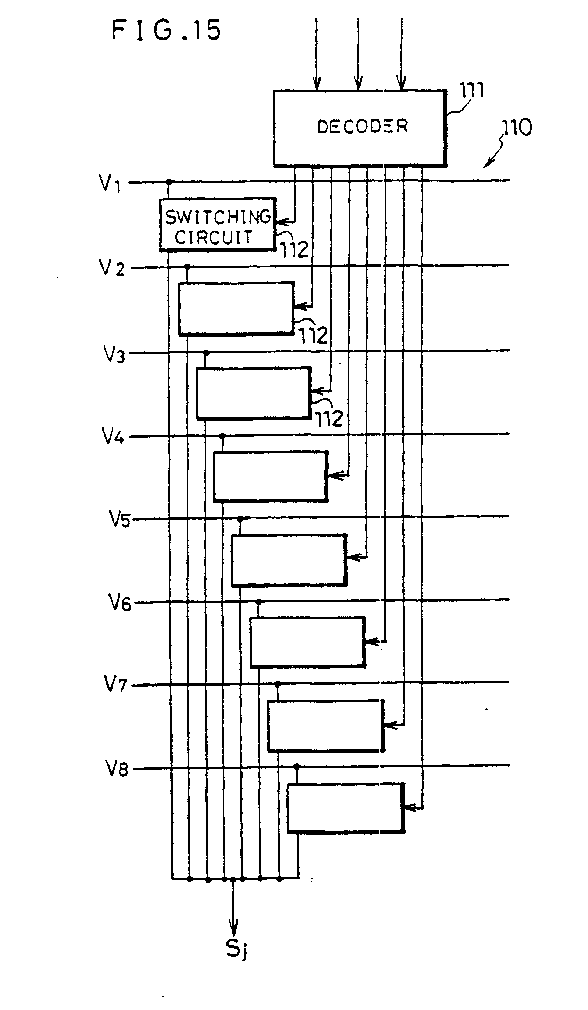

As shown in Fig. 15, the digital buffer 110 is composed of a decoder 111 for decoding a signal from the switching circuit 109 and a switching circuit 112 which makes a selection among voltage values of V1 through V8 in order to achieve the 8 gradation display according to an output from the decoder 111.

As described, in the case of digital drivers, voltage levels and switching circuits 112 are respectively required in the same number as the number of gradations. Therefore, in the case of the multiple gradation display, the circuit becomes larger in size. For this reason, the following analog driver is more suitable for the multiple gradation display.

The drive system for analog drivers is classified into the following two systems: dot sequential drive system and line sequential drive system.

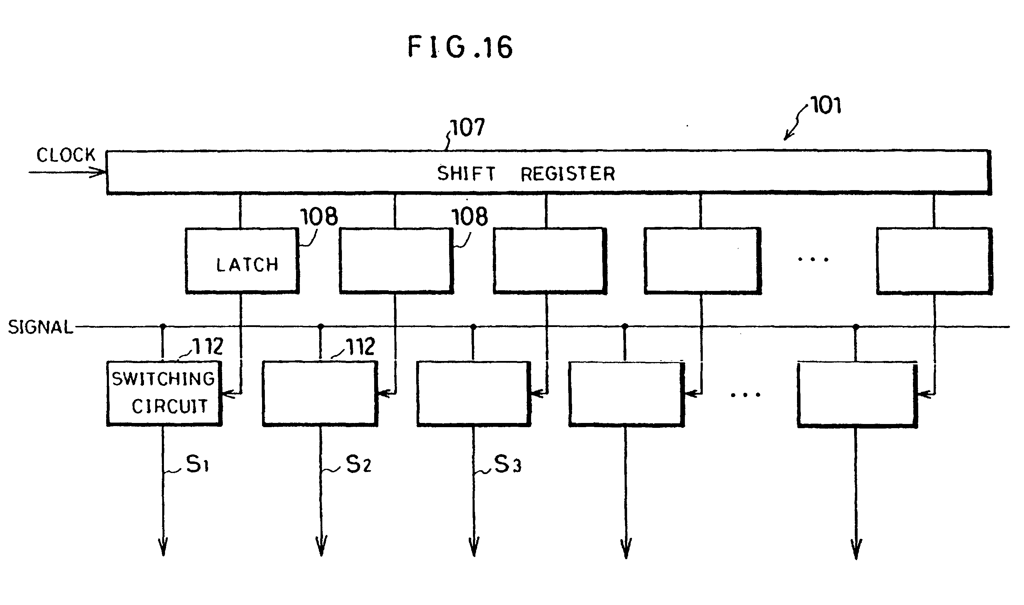

As shown in Fig. 16, an analog driver of the dot sequential drive system is composed of a shift register 107, a plurality of latches 108 and a plurality of switching circuits 112. The analog driver outputs data over the data signal line Sⱼ by opening and closing the switching circuits 112 synchronous with a pulse from each block of the shift register 107.

A period in which an output of data over the data signal line Sⱼ is permitted is H1/N where H1 indicates an effective horizontal scanning period (approximately 80 % of the horizontal scanning period) and N indicates a number of picture elements in a horizontal direction, i.e., a number of display cells Cᵢₗ to C_{iN}. For this reason, in the case of displaying on a large screen, a period for outputting data over the data signal line Sⱼ becomes short.

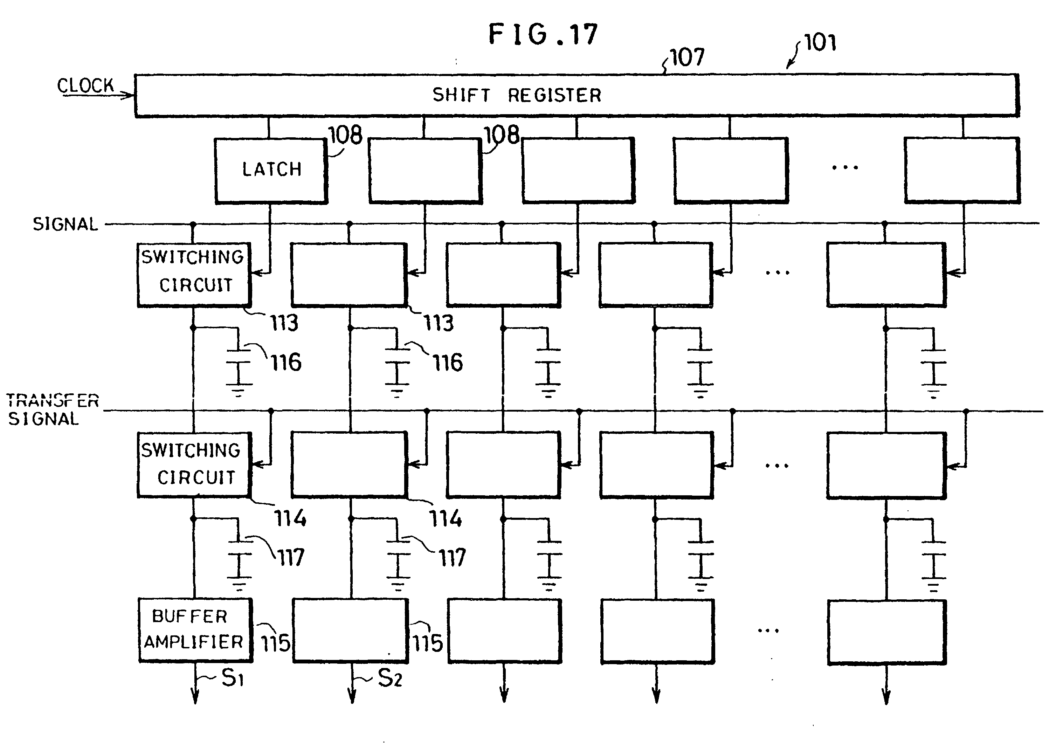

As shown in Fig. 17, an analog driver of the line sequential drive system is composed of a shift driver 107, a plurality of latches 108, a plurality of switching circuits 113, a plurality of condensers 116, a plurality of switching circuits 114, a plurality of condensers 117 and a plurality of buffer amplifiers 115 having the previously described characteristics.

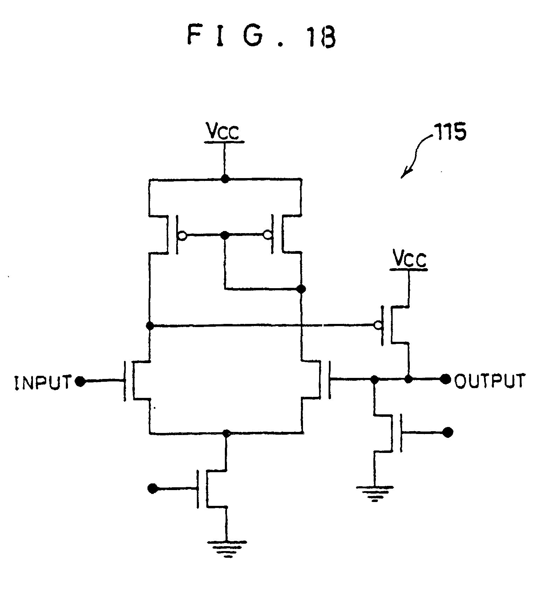

Various kinds of circuits are applicable to the buffer amplifier 115 as shown in Fig. 18 through Fig. 20.

In the line sequential drive system, data from the switching circuit 113 is temporarily held in a sampling-use condenser 116 of a small capacity, and the switching circuits 114 are turned ON by a transfer signal in the next horizontal blanking period. As a result, all the data sent in the previous horizontal scanning period are sent to the respective holding condensers 117 and the buffer amplifiers 115 at one time, and are outputted to the data signal line Sⱼ. Therefore, a sufficient length of the period for outputting data over the data signal line Sⱼ can be ensured.

In the described liquid crystal display device of the active-matrix drive system, the FET 105 of the display cell Cᵢⱼ (see Fig. 13) is formed using a thin film made of amorphous silicon formed on a transparent substrate, and drive circuits 101 and 102 are manufactured as separately provided ICs (integrated circuits). Recently, a monolithic system technology has been reported for forming the drive circuits 101 and 102 and the display 103 on a thin film made of polycrystalline silicon.

However, in the case of a transistor composed of the thin film made of polycrystalline silicon, since a particle diameter and a channel length of the transistor have the same order, properties such as a threshold voltage, mutual conductance, sub-threshold coefficient, etc., differ for each transistor. Thus, in the case of manufacturing the buffer amplifier 115 (see Fig. 18 through Fig. 20), by the transistor made of the thin film made of polycrystalline silicon, the problem is presented in that an offset voltage is generated in the buffer amplifier 115. Here, the offset voltage is defined as a difference in voltage between the input voltage and the output voltage of the buffer amplifier 115.

The offset voltage differs for each buffer-amplifier 115, and this difference in the offset voltage may exceed 1 V. In the case of the liquid crystal display having a drive voltage (dynamic range) of 5 V, if a difference of offset voltages among buffer amplifiers 115 exceeds 1 V, a multiple gradation display of above 4 gradations cannot be carried out.

In order to counteract the above problem, the Japanese Laid-Open Patent Publication No. 1425941/1992 (Tokukaihei 4-142591) discloses a liquid crystal display device wherein a voltage for cancelling out the offset voltage is stored beforehand in the memory as adjusting data, and after adding the adjusting data to a video signal, the video signal is inputted into the drive circuit 101, thereby cancelling out the offset voltage.

However, when adopting the above liquid crystal display device, the following problems are newly raised: since a memory is required, a manufacturing cost goes up; and it takes time because an offset voltage is measured beforehand for each buffer amplifier 115 before being stored in the memory.

Moreover, since a Fermi level and a carrier mobility of a semiconductor has high temperature dependency, depending of an environmental temperature at which the liquid crystal display device is operated, the offset voltage may not be cancelled out. Furthermore, when using the transistor composed of the thin film made of polycrystalline silicon, the above properties greatly change as time passes because of the reasons that many localized levels exist on a crystal grain boundary and a gate dielectric film - polycrystalline silicon interface, and the polycrystalline silicon thin film is in a state of floating potential, thereby presenting the problem that cancelling out of the offset voltage cannot be ensured for a long period of time.

As described, the following problems still remain unsolved: the offset voltage generated in the buffer amplifier 115, especially, when the buffer amplifier 115 is manufactured using the transistor composed of the polycrystalline silicon thin film, a large offset voltage generated.

Furthermore, when adopting the buffer amplifiers 115 in which offset voltage generates, since the offset voltage differs for each buffer amplifier 115, a high quality image display cannot be achieved.

US 4 781 437 discloses a signal amplifier circuit according to the preamble of claim 1. In this signal amplifier circuit the voltage at the first terminal is reset to a voltage equal to the sum of a reference voltage and the offset voltage of the amplifier. Accordingly, the voltage at the first terminal will vary from amplifier to amplifier, since the offset voltage varies between amplifiers.

A first aspect of the present invention provides a signal amplifier circuit as claimed in claim 1.

Another object of the invention is to provide an image display device which produces a high quality image.

A second aspect of the present invention provides an image display device as claimed in claim 9.

According to the above arrangement, a voltage having the same level as a voltage temporarily held in the sampling-use condenser can be sent over the data signal line. As a result, a high quality image display is enabled.

For a fuller understanding of the nature and advantages of the invention, reference should be made to the ensuing detailed description taken in conjunction with the accompanying drawings.

### BRIEF DESCRIPTION OF THE DRAWINGS

Fig. 1 through Fig. 11 and Fig. 21 show one embodiment of the present invention.

Fig. 1 is a view showing a schematic structure of a signal amplifier circuit in accordance with the present invention.

Fig. 2 is a circuit diagram showing the first example of the signal amplifier circuit of Fig. 1.

Fig. 3 is a timing chart of a control signal in the signal amplifier circuit of Fig. 2.

Fig. 4 is a circuit diagram which shows a sample configuration of a signal amplifier circuit which permits a shorter adjusting time.

Fig. 5 is a circuit diagram which shows another sample configuration of a signal amplifier circuit which permits a shorter adjusting time.

Fig. 6 is a circuit diagram which shows the second example of the signal amplifier circuit of Fig. 1.

Fig. 7 is a timing chart of a control signal in the signal amplifier circuit of Fig. 6.

Fig. 8 is a circuit diagram which shows the third example of the signal amplifier circuit of Fig. 1.

Fig. 9 is a timing chart of a control signal in the signal amplifier circuit of Fig. 8.

Fig. 10 is a block diagram which shows a schematic configuration of a liquid crystal display device as an application example of the signal amplifier circuit of Fig. 1.

Fig. 11 is a block diagram showing a schematic configuration of a drive circuit for sending data over a data signal line in the liquid crystal display device of Fig. 10.

Fig. 21 is a timing chart showing an operation of the drive circuit of Fig. 11.

Fig. 12 through Fig. 20 show prior art.

Fig. 12 is a block diagram showing a schematic configuration of a conventional image display device of an active-matrix drive system.

Fig. 13 is a circuit diagram showing a configuration of a display cell in the case where the image display device of Fig. 12 is a liquid crystal display device.

Fig. 14 is a block diagram showing a schematic configuration of a digital driver as an example of the drive circuit for sending data in the data signal line over the image display device of Fig. 12.

Fig. 15 is a block diagram showing a schematic configuration of a digital buffer in the digital driver of Fig. 14.

Fig. 16 is a block diagram showing a schematic configuration of an analog driver of a dot sequential drive system as another example of the drive circuit for sending data over the data signal line in the image display device of Fig. 12.

Fig. 17 is a block diagram showing a schematic configuration of an analog driver of a line sequential drive system as still another example of the drive circuit for sending data over the data signal line in the image display device of Fig. 12.

Fig. 18 is a circuit diagram shown an example of the buffer amplifier in the analog driver of Fig. 17.

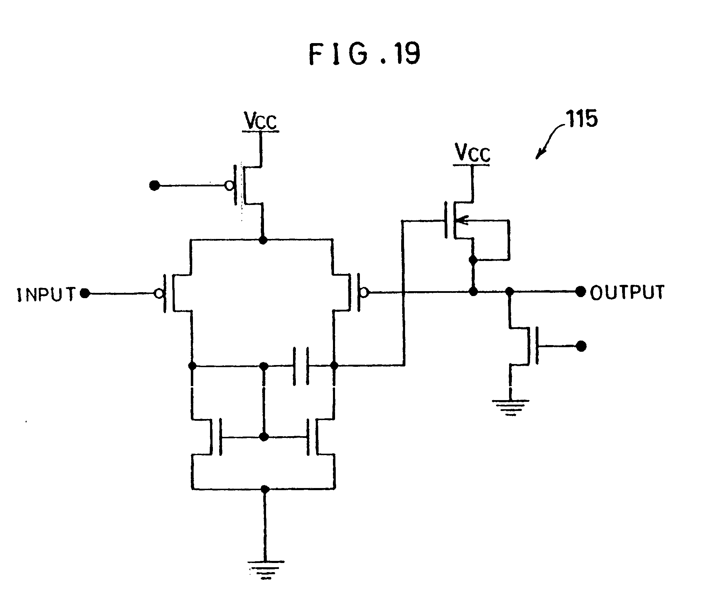

Fig. 19 is a circuit diagram showing another example of the buffer amplifier in the analog driver of Fig. 17.

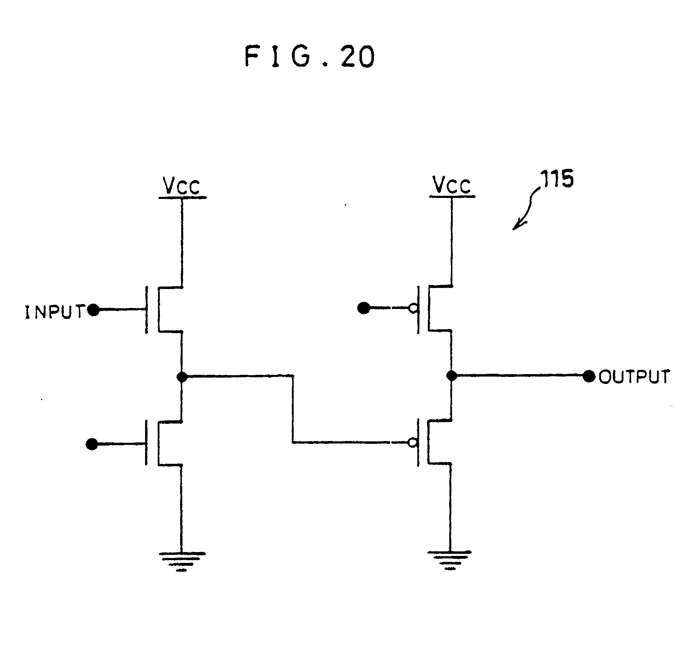

Fig. 20 is a circuit diagram showing still another example of the buffer amplifier in the analog driver of Fig. 17.

### DESCRIPTION OF THE EMBODIMENTS

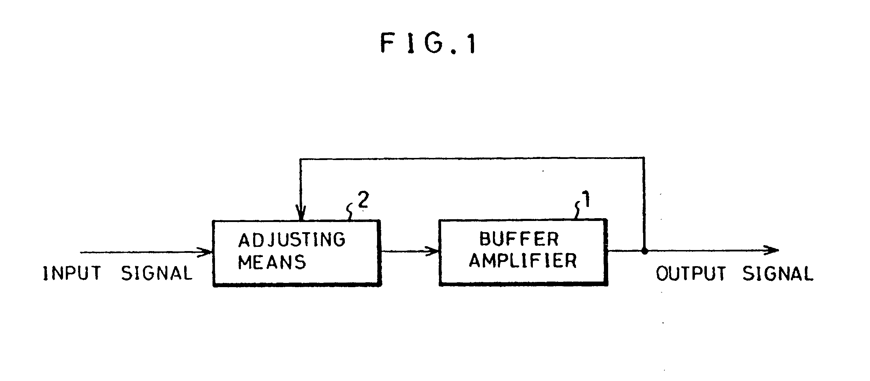

The following description will discuss embodiments of the present invention with reference to Fig. 1 through Fig. 11 and Fig. 21.

As shown in Fig. 1, a signal amplifier circuit in accordance with the present embodiment is provided with a buffer amplifier 1 and adjusting means 2 for cancelling out an offset voltage ΔV generated in the buffer amplifier 1.

The adjusting means 2 inputs a reference voltage V₀ to the buffer amplifier 1 and detects a difference between an output voltage (V₀ + ΔV) of the buffer amplifier 1 and a reference voltage V₀ as an offset voltage ΔV. Then, the adjusting means 2 inputs a voltage (V - ΔV) obtained by subtracting the offset voltage ΔV from the voltage V of the input signal into the buffer amplifier 1.

When the voltage (V - ΔV) is inputted to the buffer amplifier 1, a voltage (V - ΔV + ΔV) is outputted. Namely, the offset voltage ΔV is cancelled out, and the voltage V is outputted. According to the signal amplifier circuit of the present embodiment, even if the offset voltage ΔV is generated in the buffer amplifier 1, a desirable buffer characteristic that a signal outputted therefrom has the same voltage level as a signal inputted thereto can be achieved.

Therefore, even when the buffer amplifier 1 is manufactured using a transistor composed of a polycrystalline semiconductor or amorphous semiconductor, a signal amplifier circuit having a desirable buffer characteristic can be achieved.

It may be arranged such that the adjusting means 2 detects the offset voltage ΔV when the signal amplifier circuit starts operating. However, in the case where an input signal is inputted synchronous with a clock signal, a detection of the offset voltage ΔV is preferably carried out at every clock.

In the above arrangement where the offset voltage ΔV is cancelled out at every clock, even if the offset voltage ΔV changes due to a change in the environment under which the signal amplifier circuit operates (for example, a change in temperature) or due to a change in properties of the signal amplifier circuit as time passes, cancelling out of the offset voltage ΔV can be always ensured.

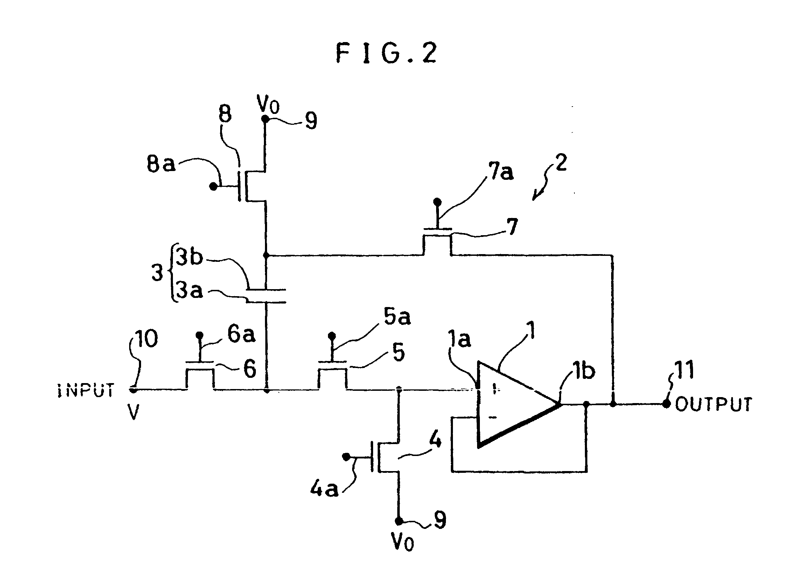

The first example of the signal amplifier circuit will be explained below in reference to Fig. 2.

The signal amplifier circuit is composed of a buffer amplifier 1 and the adjusting means 2. The adjusting means 2 is composed of a condenser 3 (first condenser) and switching elements 4-8 (first - fifth switching elements).

An input terminal 1a of the buffer amplifier 1 is connected to an input terminal 9 of a reference voltage V₀ via the switching element 4. The input terminal 1a of the buffer amplifier 1 is also connected to one electrode 3a of the condenser 3 via the switching element 5. The electrode 3a is connected to an input terminal 10 of the signal amplifier circuit via the switching element 6. The other electrode 3b of the condenser 3 is connected to an output terminal 1b of the buffer amplifier 1 via the switching element 7. The electrode 3b of the condenser 3 is also connected to an input terminal 9 via the switching element 8.

In order to stabilize a signal level, another condenser of a small capacity may be added to the input terminal 1a of the buffer amplifier 1. This is effective if respective parasitic capacities of the buffer amplifier 1 and switching elements 4 and 5 and the capacity of wires used in connecting the above components are not sufficient for stabilizing the signal level.

Hereinafter, it is assumed that the buffer amplifier 1 always generates a constant offset voltage ΔV as long as the level of an input signal falls within a predetermined range.

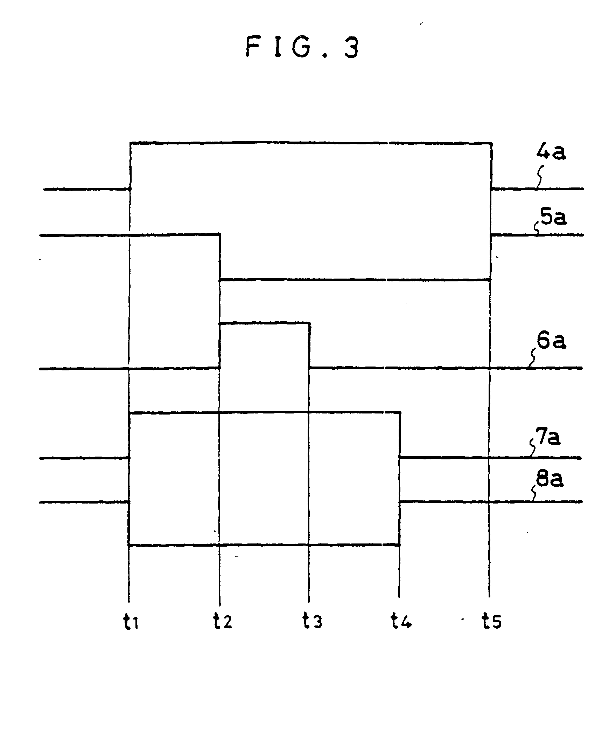

The switching elements 4-8 are respectively controlled by control signals 4a - 8a from the control means (not shown) according to a timing chart of Fig. 3.

It is shown in Fig. 3 that respective rises and falls of control signals 4a-8a completely coincide in a time period of t₁ - t₅. In practice, however, when respective levels of the control signals 4a-8a change, finite time (transition time) is required. Therefore, in order to cancel out an offset voltage ΔV accurately, it is necessary to prevent an interference by a transient signal generated at respective rises and falls of the control signals 4a-8a. For the reason above, it is preferable to prevent an interference occurring at rises and falls of the control signals 4a-8a, for example, by delaying a rise of one of the control signals 4a-8a. Additionally, the control signals 4a-8a are applicable to the case where a N-channel MOS transistor is adopted as switching elements 4-8. However, when P-channel MOS transistor is adopted as switching elements 4-8, the phase of the control signals 4a-8a should be reversed. The above features are also true of a timing chart to be described later.

At t₁, control signals 4a, 5a and 7a are High level and control signals 6a and 8a are Low level, and thus switching elements 4, 5 and 7 are set ON and switching elements 6 and 8 are set OFF.

Therefore, the reference voltage V₀ is applied to the input terminal 1a of the buffer amplifier 1 through a switching element 4; in the meantime, it is applied to the electrode 3a of the condenser 3 through the switching element 5. The output voltage (V₀ + ΔV) of the buffer amplifier 1 is applied to the electrode 3b of the condenser 3 through the switching element 7.

At t₂, the control signal 5a is set to Low level, and the control signal 6a is set to High level. As a result, the switching element 5 is set OFF, and the switching element 6 is set ON.

For this reason, an input signal having a voltage V from the input terminal 10 is applied to the electrode 3a of the condenser 3 through the switching element 6.

At t₃, the control signal 6a is set to Low level, and thus the switching element 6 is set OFF.

At t₄, the control signal 7a is set to Low level, and the control signal 8a is set to High level. As a result, the switching element 7 is set OFF, and the switching element 8 is set ON.

Therefore, the reference voltage V₀ is applied to the electrode 3b of the condenser 3 through the switching element 8. As a result, a voltage of the electrode 3a of the condenser 3 becomes a voltage (V - ΔV) obtained by shifting the voltage V of the input signal by a voltage changed in the electrode 3b (i.e., V₀ - (V₀ + ΔV) = -ΔV).

At t₅, the control signal 4a is set to Low level, and the control signal 5a is set to High level. As a result, the switching element 4 is set OFF and the switching element 5 is set ON.

Thus, a voltage (V - ΔV) of the electrode 3a of the condenser 3 is applied to the input terminal 1a of the buffer amplifier 1 through the switching element 5. As a result, the offset voltage ΔV is cancelled out, and the voltage V in the same level as the voltage V of the input signal is outputted from the output terminal 1.

In the described signal amplifier circuit, a time required for adjusting the offset voltage ΔV is (t₅ - t₁). However, by setting the load of the buffer amplifier smaller, the time required for adjusting the offset voltage ΔV can be made shorter. This is because in the adjusting period, a stabilization of the output voltage (V₀ + ΔV) of the buffer amplifier 1 when the reference voltage V₀ is inputted requires the longest time. Especially, when a difference between the input signal level and the reference voltage V₀ before adjusting the offset voltage ΔV is large, the stabilization requires a long time.

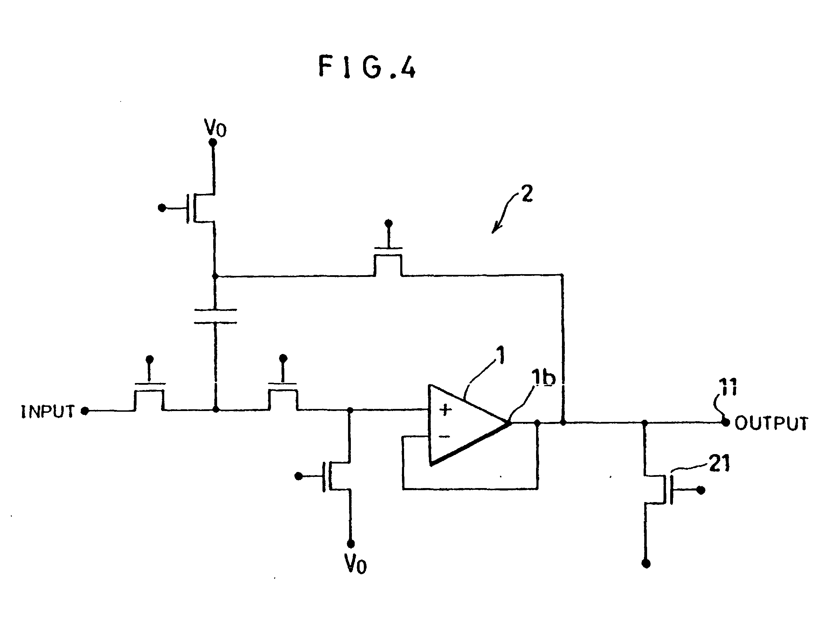

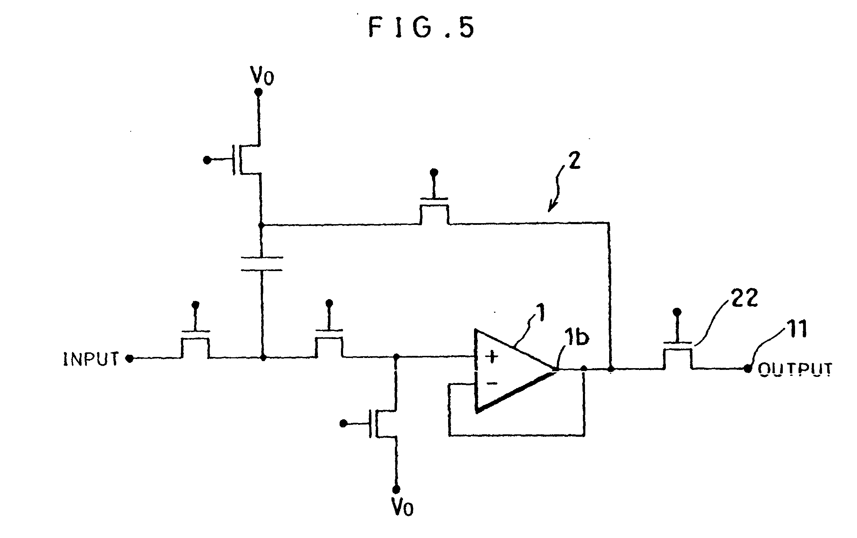

More specifically, it may be arranged such that a switching element 21 (eighth switching element) for applying a reference voltage V₀ to an output terminal 1b of the buffer amplifier in a period directly before t₁ is provided as shown in Fig. 4. Alternatively, it may be arranged such that a switching element 22 (ninth switching element) for switching off the load from the output terminal 1b of the buffer amplifier 1 in a period between t₁ and t₅ is provided as shown in Fig. 5.

For the buffer amplifier 1, a circuit shown in the explanation of prior arts (see Fig. 18 and Fig. 20) may be used. However, the present invention is not limited to this. Other circuits having the buffer characteristic may be applicable.

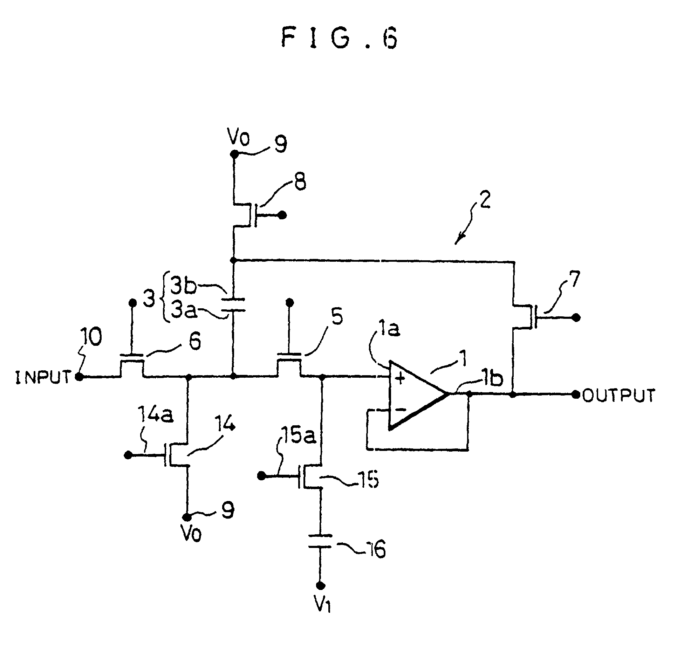

The second example of the signal amplifier circuit will be explained below in reference to Fig. 6.

In the signal amplifier circuit, the switching element 4 of the first example is not provided. Instead, switching elements 14 and 15 (sixth and seventh switching elements) and a condenser 16 holding a reference voltage V₀ (second condenser) are additionally provided.

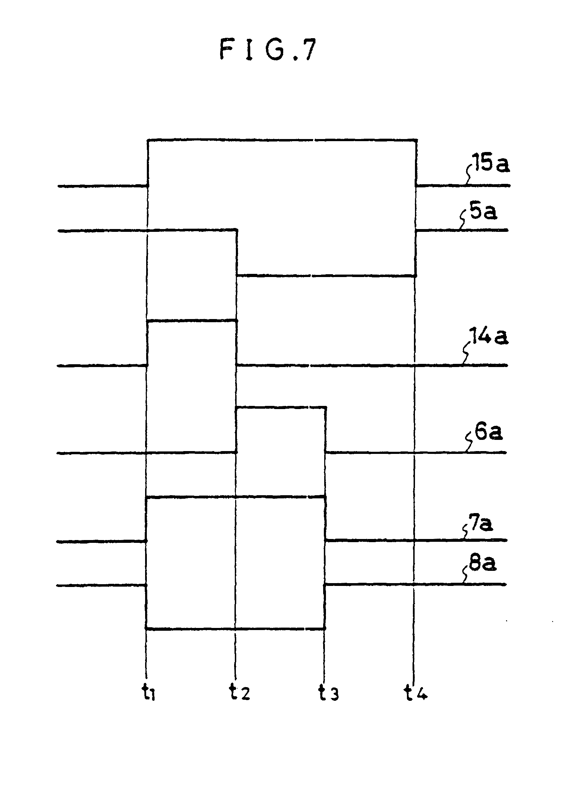

Switching elements 5-8, 14 and 15 are respectively controlled by control signals 5a - 8a, 14a and 15a from control means (not shown) according to a timing chart of Fig. 7.

At t₁, the control signals 15a, 5a, 14a and 7a are High level, and control signals 6a and 8a are Low level. Thus, the switching elements 15, 5, 14 and 7 are set ON, and the switching elements 6 and 8 are set OFF.

For this reason, the reference voltage V₀ is applied to the condenser 16 through the switching elements 14, 5 and 15. As a result, the condenser 16 is charged, and the potential of the input terminal 1a of the buffer amplifier 1 becomes the reference voltage V₀. The offset voltage ΔV is cancelled out using a voltage of the terminal on the buffer amplifier side of the condenser 16 (i.e., reference voltage V₀). Other than the above, the signal amplifier circuit of this example has approximately the same configuration as the signal amplifier circuit of the first example.

In the signal amplifier circuit of this example, a time required for adjusting the offset voltage ΔV is (t₄ - t₁) of Fig. 7.

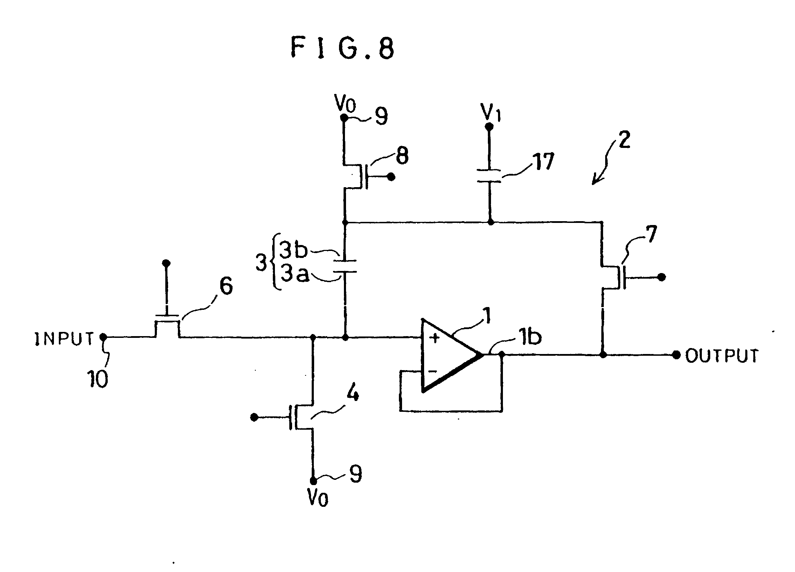

The third example of the signal amplifier circuit will be explained below in reference to Fig. 8.

In the signal amplifier circuit of this example, the switching element 5 of the first example is not provided. Instead, a condenser 17 (third condenser) for holding an output voltage from the buffer amplifier 1 is additionally provided. The electrostatic capacity of the condenser 17 is set significantly larger than that of the condenser 3.

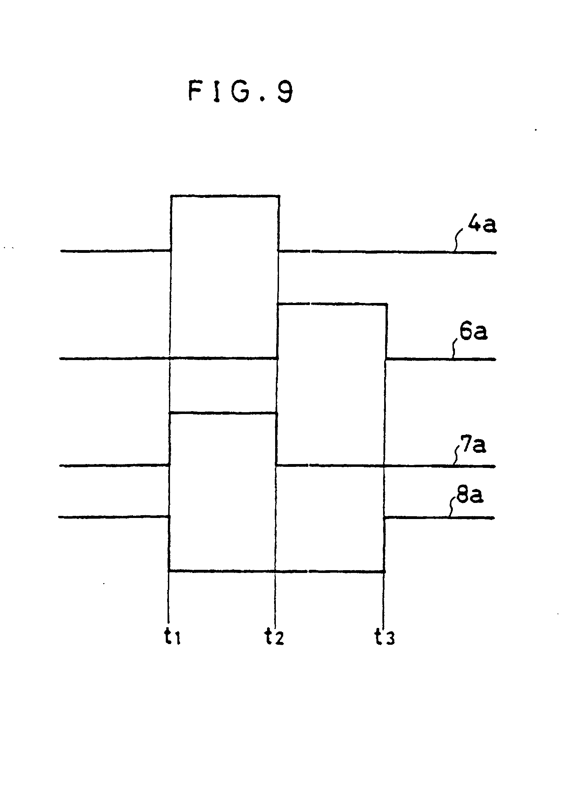

Switching elements 4 and 6-8 are respectively controlled by control signals 4a and 6a-8a from the control means (not shown) according to a timing chart of Fig. 9.

At t₁, the control signals 4a and 7a are High level, and the control signals 6a and 8a are Low level. Thus, the switching elements 4 and 7 are set ON, and the switching elements 6 and 8 are set OFF.

For this reason, the reference voltage V₀ is applied to the input terminal 1a of the buffer amplifier 1 through the switching element 4. The output voltage (V₀ + ΔV) of the buffer amplifier 1 is applied to the condenser 17 through the switching element 7. As a result, the condenser 17 is charged, and the potential of the electrode 3b of the condenser 3 becomes the output voltage (V₀ + ΔV) of the buffer amplifier 1 when the reference voltage V₀ is inputted. Then, the offset voltage ΔV is cancelled out using the voltage (V₀ + ΔV) held in the condenser 17. Other than the above, the signal amplifier circuit of this example has the same configuration as the previous example.

In the signal amplifier circuit of this example, a time required for cancelling the offset voltage ΔV is (t₃ - t₁) shown in Fig. 9.

In the present embodiment, the reference voltage V₀ is not specified as long as it falls within a range where the linearity of the buffer amplifier 1 is ensured. However, it is preferably set to a mid-value of a range of the input signal level of the signal amplifier circuit. As a result, the non-linearity of the buffer amplifier 1 can be minimized, thereby achieving an accurate signal amplifier circuit. Moreover, because a change in the output from the buffer amplifier 1 in a period required for cancelling out the offset voltage V₀ can be suppressed evenly, the time required for it can be reduced. Furthermore, since current applied to the condensers 3, 16 and 17 or switching elements 4-8, 14, 15, 21 and 22 can be made smaller, a transient generated at respective rises and falls of the control signals 4a-8a can be suppressed.

A constant voltage V₁ to be applied to an electrode of the condenser 16 on the other side of the switching element 15 and a constant voltage V₁ to be applied to an electrode of the condenser 17 on the other side of the switching element 7 are not specified as long as they are constant. However, for the reasons above, the constant voltage V₁ and V₂ are preferably set to a mid-value of a range of the input signal level of the signal amplifier circuit.

In the above examples, respective internal capacities of switching elements 4, 5... and parasitic capacities of wires are preferably set significantly smaller than the electrostatic capacity of the condenser 3 in order to surely cancel out the offset voltage ΔV.

For example, for each switching element 4, 5 ..., N-channel or P-channel MOS (metal oxide semiconductor) transistor, or a complementary MOS (CMOS) transistor switch composed of a N-channel MOS and a P-channel MOS connected in parallel may be used.

The N-channel MOS transistor and the P-channel MOS transistor, respective waveforms of gate electrodes when opening and closing a switch have phases opposite to one another. Therefore, by adopting the CMOS transistor switch, a potential shift due to the parasitic capacity between the gate electrode and the source electrode can be eliminated. For the above reason, a more accurate signal amplifier circuit can be achieved by adopting the CMOS transistor switch.

In the above preferred examples, the condensers 3, 16 and 17 are used for holding a voltage. However, the present invention is not limited to this. For example, other kinds of analog memory means or digital memory means of a plurality of bits may be used. For the analog memory means, a condenser provided between metal wiring layers or between the metal wiring layer and a semiconductor layer may be used. For the digital memory means, other than those having the same configurations as the analog memory means (condenser), a logic circuit such as a flip-flop may be used.

As an application example of the signal amplifier circuit, a liquid crystal display of an active-matrix drive system adopting the signal amplifier circuit will be explained below.

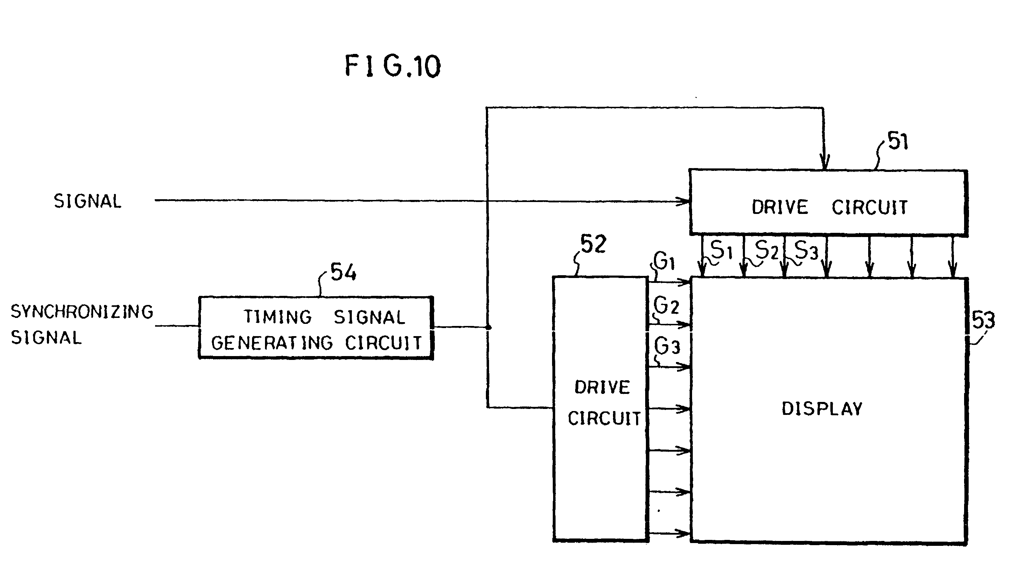

As shown in Fig. 10, the liquid display is composed of drive circuits 51 and 52 (first and second drive means), a display 53 composed of display cells arranged so as to form a matrix and a timing signal generating circuit 54 (i.e., for generating a clock signal and control signals 5a, 6a, ...) provided for controlling the drive circuits 51 and 52. The timing signal generating circuit 54 may be formed on the substrate whereon the display 53 is formed or on a substrate separately provided.

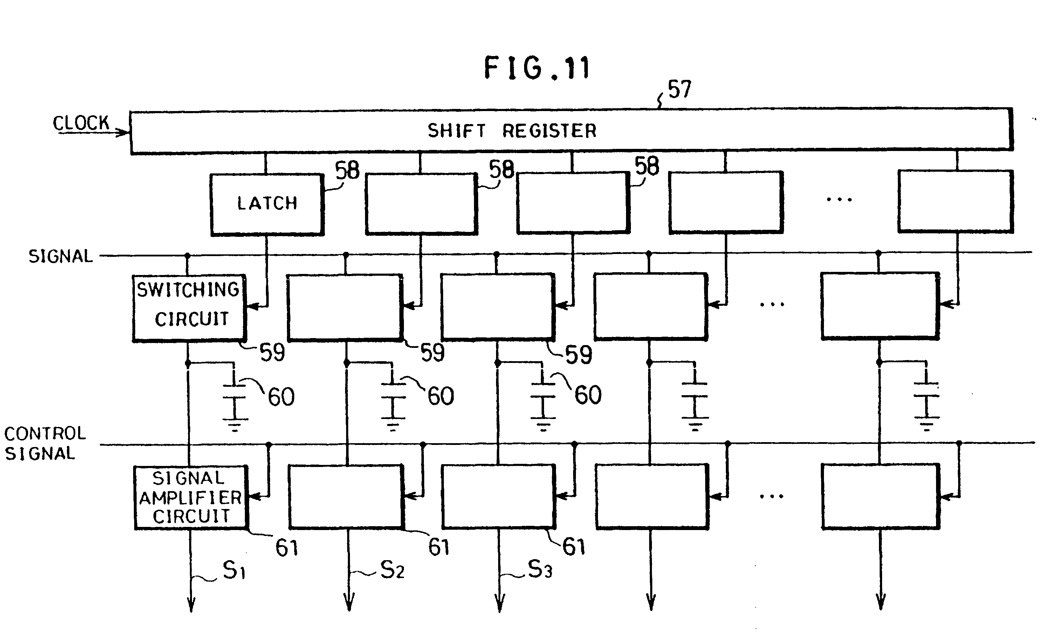

The drive circuit 51 samples a video signal synchronous with the timing signal and sends a voltage obtained by sampling as data over the data signal line Sⱼ (Fig. 11). The drive circuit 52 selects a scanning signal line Gᵢ in order (Fig. 12), and data on the data signal line Sⱼ is sent to a display cell of the display 53.

As shown in Fig. 11, an analog driver of linear sequential drive system which serves as the drive circuit 51 is composed of a shift register 57, a plurality of latches 58, a plurality of switching circuits 59, a plurality of condensers 60 and a plurality of signal amplifier circuits 61. Here, it is possible to omit latches 58.

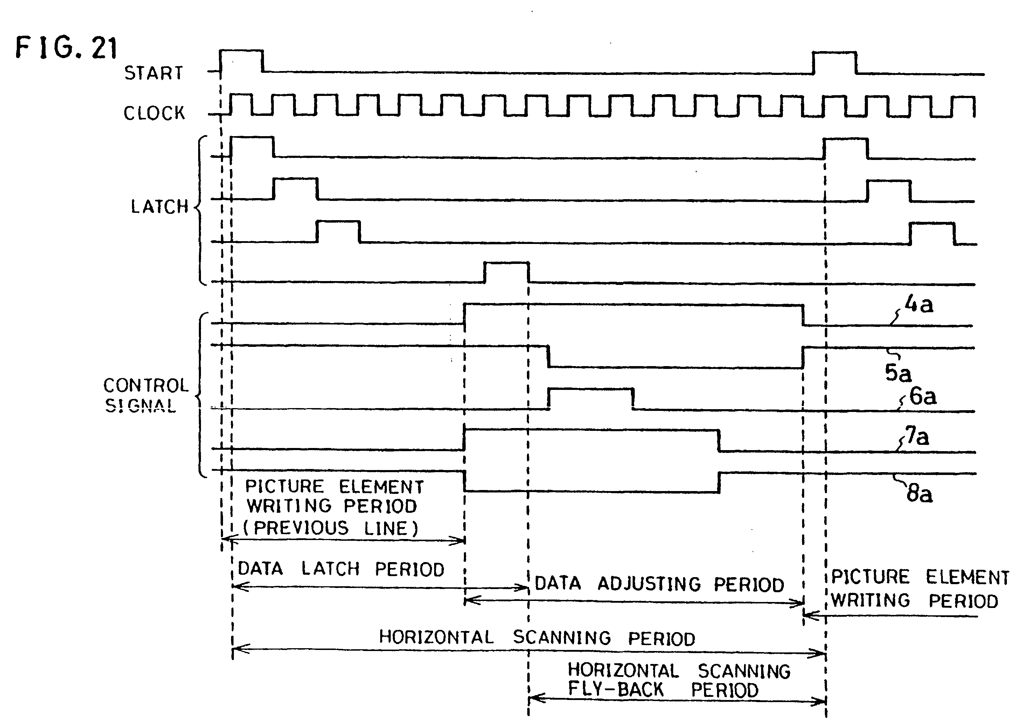

As shown in Fig. 21, the shift register 57 sends a signal over latches 58 in order synchronous with a clock signal. Each latch 58 holds a signal from the shift register 57 and shifts a signal level if necessary. Each switching circuit 59 is set ON by a signal from the latch 58, and the level of a video signal at that time is sampled to the condenser 60 as data. In the described manner, data of an effective horizontal scanning period, i.e., data of the same number as the number of picture elements in a lateral direction are held in a plurality of condensers 60 respectively.

As described, the signal amplifier circuit 61 is provided with the buffer amplifier 1 and the adjusting means 2 for cancelling out an offset voltage ΔV of the buffer amplifier 1. Additionally, in the case of a liquid crystal display, the adjusting means 2 also has a function for holding data. The data from respective condensers 60 are read in the signal amplifier circuit 61 using a control signal at one time within the horizontal blanking period. However, an adjustment of the offset voltage ΔV including the process for reading-in the data is carried out either only in the horizontal blanking period or both the horizontal blanking period and the period directly before the horizontal blanking period using the control signal. When the offset voltage ΔV is cancelled out both in the horizontal blanking period and the period directly before and after the horizontal blanking period, although a sufficient time for the adjustment can be ensured, a period for outputting the video signal over the data signal line Sⱼ may be shortened. However, this would not be a problem because the linear sequential drive system offers a long writing time.

According to the signal amplifier circuit 61 of the present embodiment, even if the offset voltage ΔV generates in the buffer amplifier 1, a voltage V of the same level as the voltage V of an input signal can be sent over the data signal line Sⱼ. As a result, a high quality image display can be ensured, thereby permitting a display 53 of a larger size.

In the above arrangement, an adjustment of an offset voltage ΔV is carried out in every horizontal blanking period. Therefore, even if the offset voltage ΔV deviates due to a change in the environment under which the liquid crystal display is operated (for example, a change in temperature), or a change in properties of the signal amplifier circuit 61 as time passes, the offset voltage ΔV can be always and surely cancelled out.

In the above liquid crystal display, a single shift register 57 has been used. However, the present invention is not limited to this. For example, n numbers of shift registers connected in parallel may be used. In this case, a sampling period will be n times of that using a single shift register 57. Namely, a sufficient sampling time can be ensured.

The drive circuits 51 and 52 and the display 53 may be formed on different substrates. However, by forming either one of the drive circuits 51 and 52 or both of the drive circuits 51 and 52 on the substrate whereon the display is formed, a liquid crystal display wherein the drive circuits 51 and 52 and the display 53 are integrated can be achieved.

A single crystal silicon thin film transistor or polycrystalline silicon thin film transistor has its carrier mobility ten times as high as the amorphous silicon thin film transistor, and thus it is suitable for the drive circuits 51 and 52. Therefore, the substrate is preferably arranged such that a single crystal silicon thin film or polycrystalline thin film is formed on a transparent substrate. In the above thin film transistors, since the respective substrates are in the floating potential state, the substrates do not affect the threshold voltage. Therefore, in the transistor for transferring a video signal, the above feature is advantageous because it is not necessary to consider a drop in the potential of a signal due to a rise in the threshold voltage.

The liquid crystal display of the present embodiment permits a high quality image display. Therefore, it is suitable not only for displaying an analog data (a video signal having a successive level change) but also for displaying a video signal having a discrete level (digital data) corresponding to the multiple gradation (above 4 gradations).

In the above preferred embodiment, the liquid crystal display has been explained as an application example of the signal amplifier circuit. However, the use of the signal amplifier circuit of the present invention is widespread. For example, it is applicable to an image display device such as a CRT (cathode-ray tube) display, VF (vacuum fluorescent) display, plasma display, EL (electroluminescence) display, etc.

Furthermore, the use of the signal amplifier circuit of the present embodiment is not limited to the image display device. It is also applicable to various devices adopting a buffer amplifier. By replacing the buffer amplifier with the signal amplifier of the present embodiment, an excellent buffer characteristic can be achieved.

The signal amplifier circuits and image display devices adopting the signal amplifier circuit disclosed in the present embodiment are for example as listed below.

The first signal amplifier circuit is provided with a buffer amplifier 1 and adjusting means 2. The adjusting means 2 detects a difference in voltage between a reference voltage V₀ and an output voltage (V₀ + ΔV) of the buffer amplifier 1 obtained when inputting the reference voltage V₀ to the buffer amplifier 1. An obtained difference in voltage is defined as an offset voltage ΔV. The adjusting means 2 cancels out the offset voltage ΔV by inputting a voltage obtained by subtracting the offset voltage ΔV from the voltage of the input signal.

According to the above arrangement, since the offset voltage ΔV can be cancelled out, a signal amplifier circuit having a desirable buffer characteristic that a signal inputted thereto has the same voltage level as a signal outputted therefrom can be ensured even if the offset voltage ΔV generates in the buffer amplifier 1.

The second signal amplifier circuit having the structure of the first signal amplifier circuit is arranged such that an input signal is inputted synchronous with a clock, and the offset voltage ΔV is cancelled out by the adjusting means 2 at every clock.

According to the arrangement of the second amplifier circuit, the following effect can be achieved in addition to the effect attained from the first signal amplifier circuit. By cancelling out the offset voltage ΔV at every clock, even if the offset voltage ΔV changes due to a change in the environment under which the signal amplifier circuit is operated (for example, change in temperature) or due to a change in characteristic of the signal amplifier circuit as time passes, cancelling out of the offset voltage ΔV can be always ensured.

The third signal amplifier circuit having the structure of the second signal amplifier circuit is arranged such that the adjusting means 2 is composed of a condenser 3 and switching elements 4-8, and that an input terminal 1a of the buffer amplifier 1 is connected to an input terminal 9 of a reference voltage V₀ through the switching element 4 and is also connected to one electrode 3a of the condenser 3 through the switching element 5. The third signal amplifier circuit is further arranged such that the electrode 3a of the condenser 3 is connected to an input terminal 10 of the input signal through the switching element 6, and the other electrode 3b of the condenser 3 is connected to an output terminal 1b of the buffer amplifier 1 through the switching element 7 and is connected to the input terminal 9 of the reference voltage V₀ through the switching element 8.

The third signal amplifier circuit enables a reduced number of components in addition to the effect of the second signal amplifier circuit.

The fourth signal amplifier circuit having the structure of the second signal amplifier circuit, the adjusting means 2 is composed of condensers 3 and 16 and switching elements 5-8, 14 and 15, and the input terminal 1a of the buffer amplifier 1 is connected to the electrode 3a of the condenser 3 through the switching element 5 and is connected to a constant voltage terminal through the switching element 15 and the condenser 16. The fourth signal amplifier circuit is further arranged such that the electrode 3a of the condenser 3 is connected to the input terminal 10 of the input signal through the switching element 6 and is connected to the input terminal 9 of the reference voltage V₀ through the switching element 14, and that the other electrode 3b of the condenser 3 is connected to the output terminal 1b of the buffer amplifier 1 through the switching element 7 and is connected to the input terminal 9 of the reference voltage V₀ through the switching element 8.

The fourth signal amplifier circuit enables a reduced number of components in addition to the effect of the second signal amplifier circuit.

The fifth signal amplifier circuit having the structure of the second signal amplifier circuit is arranged such that the adjusting means 2 is composed of condensers 3 and 17 and switching elements 4, 6-8, and the input terminal 1a of the buffer amplifier 1 is connected to the input terminal 9 of the reference voltage V₀ through the switching element 4 and is connected the electrode 3a of the condenser 3. The fifth signal amplifier circuit is further arranged such that the electrode 3a of the condenser 3 is connected to the input terminal 10 of the input signal through the switching element 6, and the other electrode 1b of the condenser 3 is connected to the other output terminal 1b of the buffer amplifier 1 through the switching element 7 and is connected to the input terminal 9 of the reference voltage V₀ through the switching element 8. The other electrode 3b of the condenser 3 is also connected to the constant voltage terminal through the condenser 17.

The fifth signal amplifier circuit enables a reduced number of components in addition to the effect of the second signal amplifier circuit.

The sixth signal amplifier circuit having the structure of the first, second, third, fourth or fifth signal amplifier circuit is arranged such that a switching element 21 is provided for applying the reference voltage V₀ to the output terminal 1b of the buffer amplifier 1.

The sixth signal amplifier circuit permits a load of the buffer amplifier 1 to be reduced in addition to the effect obtained from the effect of the first, second, third, fourth or fifth signal amplifier circuit. Therefore, a time required for cancelling out the offset voltage ΔV can be shortened.

The seventh signal amplifier circuit having the arrangement of the first, second, third, fourth or fifth signal amplifier circuit is arranged such that a switching element 22 for separating the buffer amplifier 1 from an external load is provided.

The seventh signal amplifier circuit permits a load of the buffer amplifier 1 to be reduced in addition to the effect of the first, second, third, fourth or fifth signal amplifier circuit. Therefore, a time required for cancelling out an offset voltage ΔV can be reduced.

The eighth signal amplifier circuit having the structure of the third signal amplifier circuit is arranged such that at least one of the switching elements 4-8 is a complementary MOS transistor switch.

The eighth signal amplifier circuit permits a higher accuracy compared with the signal amplifier circuit adopting a N-channel or P-channel MOS transistor switch, in addition to the effect of the third signal amplifier circuit.

The ninth signal amplifier circuit having the structure of the fourth signal amplifier circuit is arranged such that at least one of the switching elements 5, 8, 14 and 15 is a complementary MOS transistor switch.

The ninth signal amplifier circuit permits the same effect as the eighth signal amplifier circuit.

The tenth signal amplifier circuit having the structure of the fifth signal amplifier circuit is arranged such that at least one of the switching elements 4 and 6-8 is a complementary MOS transistor switch.

The tenth signal amplifier circuit permits the same effect as the eight signal amplifier circuit.

In order to achieve the above object, the first image display device of the present invention comprises a display 53 composed of display cells arranged so as to form a matrix; a drive circuit 51 for sampling a video signal so as to send a voltage obtained by sampling as data over a data signal line Sⱼ; and a drive circuit 52 for selecting a scanning signal line in order so as to send data on the data signal line Sⱼ to a display cell, wherein the drive circuit 51 comprises a shift register 57; switching circuits 59 in the same number as the number of display cells in a lateral direction; sampling-use condensers 60 in the same number as the number of switching circuits 59 and signal amplifier circuits 61 in the same number of sampling-use condensers 60. The first image display device is arranged such that the shift register 57 sends a signal to the switching circuits 59 in order in synchronous with a clock signal, and each switching circuit 59 is switched ON by a signal from the shift register 57. Furthermore, each condenser 60 samples the level of the signal as data when each switching circuit 59 is turned ON, and when data in the same number as the number of the display cells in lateral direction are held in the condensers 60, the signal amplifier circuit 61 reads in data from the condensers 60 at one time. Then, the data is outputted over the data signal line Sⱼ, thereby displaying a video signal on the display 53. In the above first image display device, the signal amplifier circuit 61 is selected among the first through tenth signal amplifier circuits.

In the first image display device, one of the first through tenth signal amplifier circuits is adopted as the signal amplifier circuit 61. Therefore, a voltage having the same level as the voltage held in a sampling-use condenser 60 can be sent over the data signal line Sⱼ. As a result, the first image display device permits a high quality image display.

The second image display device having the arrangement of the first image display device is arranged such that the display cells and drive circuits 51 are formed on the same substrate.

The second image display device permits a compact size image display device in addition to the effect of the first image display device.

The third image display device having the arrangement of the second image display device is arranged such that the substrate is composed of a transparent substrate having formed thereon a single crystal silicon thin film or polycrystalline silicon thin film formed on a transparent substrate.

In the third image display device, since the transparent substrate is used, a transmission type display device is enabled. Moreover, since an amorphous silicon thin film or a polycrystalline silicon thin film which permits a transistor having a high drive force is used, a practical drive circuit including a signal amplifier circuit can be manufactured. Especially when a transistor composed of a single crystal silicon thin film or polycrystalline silicon thin film is used, electric properties widely vary. However, with the above signal amplifier circuit, the variations can be adjusted.

The fourth image display device having the arrangement of the first, second or third image display device is arranged such that the level of the video signal is successive.

According to the fourth image display device, an image can be displayed with a successively varying gradation in addition to the effects of the first through third image display devices. Moreover, reversing of the gradation occurred when varying the gradation at every vertical line can be prevented.

The fifth image display device having the arrangement of the first, second or third image display device is arranged such that the video signal is discrete having at least four levels.

The fifth image display device offers the same effect of the fourth embodiment.

The sixth image display device having the arrangement of the first, second, third, fourth or fifth image display device is arranged such that each display cell includes a liquid crystal display element.

According to the arrangement of the sixth image display device, since each display cell includes the liquid crystal display element, in addition to the effects of the first through fifth image display devices, a display element having a uniform display characteristic can be obtained. Therefore, only by cancelling out the offset voltage ΔV generated in the buffer amplifier 1, a high quality image can be displayed.

The invention being thus described, it will be obvious that the same may be varied in many ways.

The scope of the invention is accordingly determined not by the above description but by the appended claims.

## Claims

1. A signal amplifier circuit including:
an input terminal (10) for receiving an input signal having a first voltage level;
a first terminal (3a);
switching means (6) disposed between the input terminal (10) and the first terminal (3a) for applying a signal having the first voltage level (V) to the first terminal (3a) when the switching means is closed;
a buffer amplifier (1); and
adjusting means;
**characterised in that** the adjusting means (2, 3) is for storing a difference between the first voltage level and the sum of a reference voltage (V0) and an offset voltage (ΔV) of said buffer amplifier (1) between the first terminal (3a) and a second terminal (3b), the sum of the reference voltage (V0) and the offset voltage (ΔV) being obtained as an output voltage from said buffer amplifier when the reference voltage (V0) is input thereto, and for subsequently inputting a voltage (V-ΔV) obtained by subtracting the offset voltage (ΔV) from the first voltage level by applying the reference voltage to the second terminal into said buffer amplifier (1) so as to cancel out the offset voltage (ΔV);
and **in that** the adjusting means (2) is provided with means (4, 14) for resetting the voltage at said first terminal (3a) to the reference voltage (V0) before the switching means (6) is closed.

2. The signal amplifier circuit as set forth in claim 1, wherein:
the input signal is inputted synchronous with a clock, and the offset voltage is cancelled out every clock by said adjusting means.

3. The signal amplifier circuit as set forth in claim 1 or 2, wherein:
said adjusting means is composed of a first condenser (3) and first, second, fourth and fifth switching elements (4, 5, 7, 8);
an input terminal of said buffer amplifier (1) is connected to an input terminal (9) of the reference voltage through the first switching element (4) and to one electrode of the first condenser which serves as the first terminal (3a) through the second switching element (5);
the other electrode (3b) of the first condenser (3) serves as the second terminal and is connected to an output terminal (1b) of said buffer amplifier (1) through the fourth switching element (7) and to the input terminal (9) of the reference voltage through the fifth switching element (8).

4. A signal amplifier circuit as set forth in claim 1 or 2, wherein:
said adjusting means is composed of first and second condensers (3,16) and second and fourth to seventh switching elements;
an input terminal (1a) of said buffer amplifier (1) is connected to one electrode (3a) of the first condenser which serves as the first terminal (3a) through the second switching element (5) and to a terminal (V₁) of a constant voltage through the seventh switching element (15) and the second condenser (16);
said one electrode (3a) of the first condenser (3) is connected to an input terminal (9) of the reference voltage through the sixth switching element (14); and
the other electrode (3b) of the first condenser (3) serves as the second terminal and is connected to an output terminal (16) of said buffer amplifier (1) through the fourth switching element (7) and to the input terminal (9) of the reference voltage through the fifth switching element (8).

5. A signal amplifier circuit as set forth in claim 1 or 2, wherein:
said adjusting means is composed of first and third condensers (3,17) and first, fourth and fifth switching elements;
an input terminal of said buffer amplifier (1) is connected to an input terminal (9) of the reference voltage through the first switching element (4) and to one electrode (3a) of the first condenser (3),
said one electrode of said first condenser serving as the first terminal (3a);
the other electrode of the first condenser (3) serves as the second terminal (3b) and is connected to an output terminal (1b) of said buffer amplifier through the fourth switching element (7) and to an input terminal (9) of the reference voltage through the fifth switching element (8); and
the other electrode (3b) of the first condenser (3) is connected to a terminal of a constant voltage through the third condenser (17).

6. A signal amplifier circuit as set forth in claim 1, 2, 3, 4 or 5 wherein:
an eighth switching element for applying the reference voltage to an output from said buffer amplifier is provided.

7. A signal amplifier circuit as set forth in claim 1, 2, 3, 4 or 5 wherein:
a ninth switching element for separating said buffer amplifier from an external load is provided.

8. A signal amplifier circuit as set forth in claim 3, 4 or 5 wherein:
at least one of the switching means or the switching elements is a complementary MOS transistor switch.

9. An image display device comprising:
a display (53) composed of display cells (Cij) arranged so as to form a matrix;
a first drive circuit (51) for sampling a video signal so as to send a voltage obtained as data by sampling over a data signal line (Sj); and
a second drive circuit (52) for selecting a scanning signal line (Gi) in order so as to send data on the data signal line to each display cell,
wherein said first drive circuit (51) includes:
a shift register (57);
switching circuits (59) in the same number as the number of display cells in a lateral direction;
sampling-use condensers (60) in the same number as the number of said switching circuits; and
signal amplifier circuits (61) in the same number as the number of said sampling-use condenser (60),
whereby, in use, said shift register sends a signal in order into each switching circuit synchronous with a clock signal,
the switching circuit is then set ON when receiving a signal from said shift register,
each sampling-use condenser (60) samples a level of a video signal obtained as data when the switching circuit is set ON,
whereby when data in the same number as the number of the display cells in a lateral direction are held in said sampling-use condensers, said signal amplifier circuits take-in the data from said sampling-use condensers at one time and output the data over the data signal line, thereby displaying the video signal on said display;
wherein said signal amplifier circuit includes:
an input terminal (10) for receiving an input signal having a first voltage level;
a first terminal (3a);
switching means (6) disposed between the input terminal (10) and the first terminal (3a) for applying a signal having the first voltage level (V) to the first terminal (3a) when the switching means is closed;
a buffer amplifier (1); and
adjusting means;
**characterised in that** the adjusting means (2, 3) is for storing a difference between the first voltage level and the sum of a reference voltage (V0) and an offset voltage (ΔV) of said buffer amplifier (1) between the first terminal (3a) and a second terminal (3b), the sum of the reference voltage (V0) and the offset voltage (ΔV) being obtained as an output voltage from said buffer amplifier when the reference voltage (V0) is input thereto, and for subsequently inputting a voltage (V-ΔV) obtained by subtracting the offset voltage (ΔV) from the first voltage level (V) by applying the reference voltage to the second terminal into said buffer amplifier (1) so as to cancel out the offset voltage (ΔV);
and **in that** the adjusting means (2) is provided with means (4, 14) for resetting the voltage at said first terminal (3a) to the reference voltage (V0) before the switching means (6) is closed.

10. An image display device as claimed in claim 9, wherein:
the offset voltage is cancelled out by said adjusting means every clock.

11. An image display device as claimed in claim 10, wherein:
said adjusting means is composed of a first condenser (3) and first, second, fourth and fifth switching elements (4, 5, 7, 8);
an input terminal (1a) of said buffer amplifier (1) is connected to an input terminal (9) of the reference voltage through the first switching element (4) and to one electrode of the first condenser which serves as the first terminal (3a) through the second switching element (5); and
the other electrode (3b) of the first condenser (3) serves as the second terminal (3b) and is connected to an output terminal (1b) of said buffer amplifier (1) through the fourth switching element (7) and to the input terminal (9) of the reference voltage through the fifth switching element (8).

12. An image display device as set forth in claim 10, wherein:
said adjusting means is composed of first and second condensers (3,16) and second and fourth to seventh switching elements;
an input terminal of said buffer amplifier is connected to one electrode of the first condenser which serves as the first terminal (3a) through the second switching element (5) and to a terminal (V₁) of a constant voltage through the seventh switching element (15) and the second condenser (16),
said one electrode (3a) of the first condenser (3) is connected the to an input terminal (9) of a reference voltage through the sixth switching element (14), and
the other electrode (3b) of the first condenser (3) serves as the second terminal (3b) and is connected to an output terminal (1b) of said buffer amplifier (1) through the fourth switching element (7) and to the input terminal (9) of the reference voltage through the fifth switching element (8).

13. An image display device as set forth in claim 10, wherein:
said adjusting means is composed of first and third condensers (3, 16) and first, fourth and fifth switching elements;
an input terminal (1a) of said buffer amplifier (1) is connected to an input terminal (9) of a reference voltage through the first switching element (4) and to one electrode (3a) of the first condenser (3),
said one electrode of said first condenser serving as the first terminal (3a);
the other electrode (3b) of the first condenser (3) serves as the second terminal (3b) and is connected to an output terminal of said buffer amplifier through the fourth switching element and to the input terminal of the reference voltage through the fifth switching element; and
the other electrode of the first condenser is also connected to a terminal of a constant voltage through the third condenser.

14. The image display device as set forth in claim 9, 10, 11, 12 or 13 wherein:
an eighth switching element for applying the reference voltage to an output from said buffer amplifier is provided.

15. The image display device as set forth in claim 9, 10, 11, 12 or 13 wherein:
a ninth switching element for separating said buffer amplifier from an external load is provided.

16. The image display device as set forth in claim 11, 12 or 13 wherein:
at least one of the switching means or the switching elements is a complementary MOS transistor switch.

17. The image display device as set forth in claim 9 , wherein:
said display cells and said first drive circuit are formed on the same substrate.

18. The image display device as set forth in claim 17, wherein said substrate comprises:
a transparent substrate having formed thereon an amorphous silicon thin film or polycrystalline silicon thin film.

19. The image display device as set forth in claim 9, 17 or 18, wherein:
a level of the video signal is consecutive.

20. The image display device as set forth in claim 9, 17 or 18, wherein:
the video signal is discrete having at least four levels.

21. The image display device as set forth in claim 9, 17, 18, 19, 20, 21 or 22, wherein:
each display cell includes a liquid crystal display element.

22. The signal amplifier circuit as set forth in claim 1, wherein said adjusting means includes:
a first condenser; and
switching means which applies an output voltage from said buffer amplifier when a reference voltage is inputted thereto to a first electrode of the first condenser which serves as the second terminal (3b) , and thereafter, applies the reference voltage to the first electrode of the condenser and connects the second electrode to said buffer amplifier.

23. A signal amplifier circuit as claimed in claim 1, and further comprising a condenser (60) for withholding the voltage level (V) of the input signal, the condenser being connected to the first terminal (3a) through the switching means (6).

## Patentansprüche

1. Signalverstärkerschaltung mit:
- einem Eingangsanschluss (10) zum Empfangen eines Eingangssignals mit einem ersten Spannungspegel;
- einem ersten Anschluss (3a);
- einer Schalteinrichtung (6), die zwischen dem Eingangsanschluss (10) und dem ersten Anschluss (3a) angeordnet ist, um ein Signal mit dem ersten Spannungspegel (V) an den ersten Anschluss (3a) anzulegen, wenn sie geschlossen ist;
- einem Pufferverstärker (1); und
- einer Einstelleinrichtung;
**dadurch gekennzeichnet, dass** die Einstelleinrichtung (2, 3) zum Speichern der Differenz zwischen dem ersten Spannungspegel und der Summe aus einer Bezugsspannung (V0) und einer Versatzspannung (ΔV) des Pufferverstärkers (1) zwischen dem ersten Anschluss (3a) und einem zweiten Anschluss (3b) dient, wobei die Summe aus der Bezugsspannung (V0) und der Versatzspannung (ΔV) als Ausgangsspannung des Pufferverstärkers ausgegeben wird, wenn in diesen die Bezugsspannung (V0) eingegeben wird, und zum anschließenden Eingeben einer Spannung (V-ΔV), die dadurch erhalten wird, dass die Versatzspannung (ΔV), dadurch vom ersten Spannungspegel abgezogen wird, dass die Bezugsspannung am zweiten Anschluss in den Pufferverstärker (1) eingegeben wird, um die Versatzspannung (ΔV) aufzuheben;
- und dass die Einstelleinrichtung (2) mit einer Einrichtung (4, 14) zum Rückstellen der Spannung am ersten Anschluss (3a) auf die Bezugsspannung (V0) vor dem Schließen der Schalteinrichtung (6) versehen ist.

2. Signalverstärkerschaltung nach Anspruch 1, bei der das Eingangssignal synchron mit einem Taktsignal eingegeben wird und die Versatzspannung durch die Einstelleinrichtung für jedes Taktsignal aufgehoben wird.

3. Signalverstärkerschaltung nach Anspruch 1 oder 2, bei der
- die Einstelleinrichtung aus einem ersten Kondensator (3) und einem ersten, einem zweiten, einem vierten und einem fünften Schaltelement (4, 5, 7, 8) besteht;
- ein Eingangsanschluss des Pufferverstärkers (1) mit einem Eingangsanschluss (9) der Bezugsspannung über das erste Schaltelement (4) und mit einer Elektrode des ersten Kondensators, die als erster Anschluss (3a) dient, über das zweite Schaltelement (5) verbunden ist;
- die andere Elektrode (3b) des ersten Kondensators (3) als zweiter Anschluss dient und sie mit dem Ausgangsanschluss (1b) des Pufferverstärkers (1) über das vierte Schaltelement (7) und mit dem Eingangsanschluss (9) der Bezugsspannung über das fünfte Schaltelement (8) verbunden ist.

4. Signalverstärkerschaltung nach Anspruch 1 oder 2, bei der
- die Einstelleinrichtung aus einem ersten und einem zweiten Kondensator (3, 16) und einem zweiten (1a) sowie einem vierten bis sechsten Schaltelement besteht;
- ein Eingangsanschluss (1a) des Pufferverstärkers (1) mit einer Elektrode (3a) des ersten Kondensators, die als erster Anschluss (3a) dient, über das zweite Schaltelement (5) und einem Anschluss (V₁) einer Konstantspannung über das siebte Schaltelement (15) und den zweiten Kondensator (16) verbunden ist,
- diese eine Elektrode (3a) des ersten Kondensators (3) mit einem Eingangsanschluss (9) der Bezugsspannung über das sechste Schaltelement (14) verbunden ist; und
- die andere Elektrode (3b) des ersten Kondensators (3) als zweiter Anschluss dient und sie über das vierte Schaltelement (7) mit dem Ausgangsanschluss (1b) des Pufferverstärkers (1) und über das fünfte Schaltelement (8) mit dem Eingangsanschluss (9) der Bezugsspannung verbunden ist.

5. Signalverstärkerschaltung nach Anspruch 1 oder 2, bei der
- die Einstelleinrichtung aus einem ersten und einem dritten Kondensator (3, 17) sowie einem ersten, einem vierten und einem fünften Schaltelement besteht;
- ein Eingangsanschluss des Pufferverstärkers (1) über das erste Schaltelement (4) mit einem Eingangsanschluss (9) der Bezugsspannung sowie einer Elektrode (3a) des ersten Kondensators (3) verbunden ist;
- diese eine Elektrode des ersten Kondensators als erster Anschluss (3a) dient;
- die andere Elektrode des ersten Kondensators (3) als zweiter Anschluss (3b) dient und sie über das vierte Schaltelement (7) mit dem Ausgangsanschluss (1b) des Pufferverstärkers und über das fünfte Schaltelement (8) mit einem Eingangsanschluss (9) der Bezugsspannung verbunden ist; und
- die andere Elektrode (3b) des ersten Kondensators (3) über den dritten Kondensator (17) mit einem Konstantspannungsanschluss verbunden ist.

6. Signalverstärkerschaltung nach Anspruch 1, 2, 3, 4 oder 5, bei der ein achtes Schaltelement zum Anlegen der Bezugsspannung an einen Ausgang des Pufferverstärkers vorhanden ist.

7. Signalverstärkerschaltung nach Anspruch 1, 2, 3, 4 oder 5, bei der ein neuntes Schaltelement zum Trennen des Pufferverstärkers von einer externen Last vorhanden ist.

8. Signalverstärkerschaltung nach Anspruch 3, 4 oder 5, bei der die Schalteinrichtung und/oder die Schaltelemente aus einem Komplementär-MOS-Transistorschalter bestehen.

9. Bildanzeigevorrichtung mit:
- einem Display (53), das aus Anzeigezellen (Cij) besteht, die so angeordnet sind, dass sie eine Matrix bilden;
- einer ersten Treiberschaltung (51) zum Abtasten eines Videosignals, um eine durch Abtastung als Daten erhaltene Spannung über eine Datensignalleitung (Sj) zu senden; und
- einer zweiten Treiberschaltung (52) zum Auswählen einer Scansignalleitung (Gi), um Daten auf der Datensignalleitung an jede Anzeigezelle zu senden;
- wobei die erste Treiberschaltung (51) Folgendes aufweist:
-- ein Schieberegister (57);
-- Schaltstufen (59), deren Anzahl mit der Anzahl von Anzeigezellen in der Querrichtung übereinstimmt;
-- Kondensatoren (60) zu Abtastzwecken, deren Anzahl mit der Anzahl der Schaltstufen übereinstimmt; und
-- Signalverstärkerschaltungen (61), deren Anzahl mit der Anzahl der Kondensatoren (60) zu Abtastzwecken übereinstimmt;
- wobei im Gebrauch
-- das Schieberegister der Reihe nach ein Signal synchron mit einem Taktsignal an jede Schaltstufe sendet;
-- die Schaltstufe auf EIN gesetzt wird, wenn sie ein Signal vom Schieberegister empfängt;
-- jeder Kondensator (60) zu Abtastzwecken den Pegel eines Videosignals abtastet, wie es als Daten erhalten wird, wenn die Schaltstufe auf EIN gestellt ist;
-- wobei dann, wenn Daten entsprechend der Anzahl der Anzeigezellen in der Querrichtung in den Kondensatoren zu Abtastzwecken gehalten werden, die Signalverstärkerschaltungen die Daten von diesen auf einmal aufnehmen und die Daten über die Datensignalleitung ausgeben, um dadurch das Videosignal auf dem Display anzuzeigen;
wobei die Signalverstärkerschaltung mit Folgendem versehen ist:
- einem Eingangsanschluss (10) zum Empfangen eines Eingangssignals mit einem ersten Spannungspegel;
- einem ersten Anschluss (3a);
- einer Schalteinrichtung (6), die zwischen dem Eingangsanschluss (10) und dem ersten Anschluss (3a) angeordnet ist, um ein Signal mit dem ersten Spannungspegel (V) an den ersten Anschluss (3a) anzulegen, wenn sie geschlossen ist;
- einem Pufferverstärker (1); und
- einer Einstelleinrichtung;
**dadurch gekennzeichnet, dass** die Einstelleinrichtung (2, 3) zum Speichern der Differenz zwischen dem ersten Spannungspegel und der Summe aus einer Bezugsspannung (V0) und einer Versatzspannung (ΔV) des Pufferverstärkers (1) zwischen dem ersten Anschluss (3a) und einem zweiten Anschluss (3b) dient, wobei die Summe aus der Bezugsspannung (V0) und der Versatzspannung (ΔV) als Ausgangsspannung des Pufferverstärkers ausgegeben wird, wenn in diesen die Bezugsspannung (V0) eingegeben wird, und zum anschließenden Eingeben einer Spannung (V-ΔV), die dadurch erhalten wird, dass die Versatzspannung (ΔV) dadurch vom ersten Spannungspegel abgezogen wird, dass die Bezugsspannung am zweiten Anschluss in den Pufferverstärker (1) eingegeben wird, um die Versatzspannung (ΔV) aufzuheben;
- und dass die Einstelleinrichtung (2) mit einer Einrichtung (4, 14) zum Rückstellen der Spannung am ersten Anschluss (3a) auf die Bezugsspannung (V0) vor dem Schließen der Schalteinrichtung (6) versehen ist.

10. Bildanzeigevorrichtung nach Anspruch 9, bei der die Versatzspannung mit jedem Taktsignal durch die Einstelleinrichtung aufgehoben wird.

11. Bildanzeigevorrichtung nach Anspruch 10, bei der
- die Einstelleinrichtung aus einem ersten Kondensator (3) und einem ersten, einem zweiten, einem vierten und einem fünften Schaltelement (4, 5, 7, 8) besteht;
- ein Eingangsanschluss des Pufferverstärkers (1) mit einem Eingangsanschluss (9) der Bezugsspannung über das erste Schaltelement (4) und mit einer Elektrode des ersten Kondensators, die als erster Anschluss (3a) dient, über das zweite Schaltelement (5) verbunden ist;
- die andere Elektrode (3b) des ersten Kondensators (3) als zweiter Anschluss dient und sie mit dem Ausgangsanschluss (1b) des Pufferverstärkers (1) über das vierte Schaltelement (7) und mit dem Eingangsanschluss (9) der Bezugsspannung über das fünfte Schaltelement (8) verbunden ist.

12. Bildanzeigevorrichtung nach Anspruch 10, bei der
- die Einstelleinrichtung aus einem ersten und einem zweiten Kondensator (3, 16) und einem zweiten (1a) sowie einem vierten bis sechsten Schaltelement besteht;
- ein Eingangsanschluss (1a) des Pufferverstärkers (1) mit einer Elektrode (3a) des ersten Kondensators, die als erster Anschluss (3a) dient, über das zweite Schaltelement (5) und einem Anschluss (V₁) einer Konstantspannung über das siebte Schaltelement (15) und den zweiten Kondensator (16) verbunden ist,
- diese eine Elektrode (3a) des ersten Kondensators (3) mit einem Eingangsanschluss (9) der Bezugsspannung über das sechste Schaltelement (14) verbunden ist; und
- die andere Elektrode (3b) des ersten Kondensators (3) als zweiter Anschluss dient und sie über das vierte Schaltelement (7) mit dem Ausgangsanschluss (1b) des Pufferverstärkers (1) und über das fünfte Schaltelement (8) mit dem Eingangsanschluss (9) der Bezugsspannung verbunden ist.

13. Bildanzeigevorrichtung nach Anspruch 10, bei der
- die Einstelleinrichtung aus einem ersten und einem dritten Kondensator (3, 17) sowie einem ersten, einem vierten und einem fünften Schaltelement besteht;
- ein Eingangsanschluss des Pufferverstärkers (1) über das erste Schaltelement (4) mit einem Eingangsanschluss (9) der Bezugsspannung sowie einer Elektrode (3a) des ersten Kondensators (3) verbunden ist;
- diese eine Elektrode des ersten Kondensators als erster Anschluss (3a) dient;
- die andere Elektrode des ersten Kondensators (3) als zweiter Anschluss (3b) dient und sie über das vierte Schaltelement (7) mit dem Ausgangsanschluss (1b) des Pufferverstärkers und über das fünfte Schaltelement (8) mit einem Eingangsanschluss (9) der Bezugsspannung verbunden ist; und
- die andere Elektrode (3b) des ersten Kondensators (3) über den dritten Kondensator (17) mit einem Konstantspannungsanschluss verbunden ist.

14. Bildanzeigevorrichtung nach Anspruch 9, 10, 11, 12 oder 13, bei der ein achtes Schaltelement zum Anlegen der Bezugsspannung an einen Ausgang des Pufferverstärkers vorhanden ist.

15. Bildanzeigevorrichtung nach Anspruch 9, 10, 11, 12 oder 13, bei der ein neuntes Schaltelement zum Trennen des Pufferverstärkers von einer externen Last vorhanden ist.

16. Bildanzeigevorrichtung nach Anspruch 11, 12 oder 13, bei der die Schalteinrichtung und/oder die Schaltelemente aus einem Komplementär-MOS-Transistorschalter bestehen.

17. Bildanzeigevorrichtung nach Anspruch 9, bei der die Anzeigezellen und die erste Treiberschaltung auf demselben Substrat ausgebildet sind.

18. Bildanzeigevorrichtung nach Anspruch 17, bei der das Substrat ein transparentes Substrat aufweist, auf dem ein Dünnfilm aus amorphem oder polykristallinem Silicium ausgebildet ist.

19. Bildanzeigevorrichtung nach Anspruch 9, 17 oder 18, bei der der Pegel des Videosignals fortläuft.

20. Bildanzeigevorrichtung nach Anspruch 9, 17 oder 18, bei der das Videosignal diskret ist und mindestens vier Pegel aufweist.

21. Bildanzeigevorrichtung nach Anspruch 9, 17, 18, 19, 20, 21 oder 22, bei der jede Anzeigezelle über ein Flüssigkristall-Anzeigeelement verfügt.

22. Signalverstärkerschaltung nach Anspruch 1, bei der die Einstelleinrichtung Folgendes aufweist:
- einen ersten Kondensator und
- eine Schalteinrichtung, die die Ausgangsspannung des Pufferverstärkers, wenn eine Bezugsspannung an ihn angelegt wird, an eine erste Elektrode des ersten Kondensators, die als zweiter Anschluss (3b) dient, eingegeben wird, und danach die Bezugsspannung an die erste Elektrode des Kondensators anlegt und die zweite Elektrode mit dem Pufferverstärker verbindet.

23. Signalverstärkerschaltung nach Anspruch 1, ferner mit einem Kondensator (60) zum Aufrechterhalten des Spannungspegels (V) des Eingangssignals, der über die Einstelleinrichtung (6) mit dem ersten Anschluss (3a) verbunden ist.

## Revendications

1. Circuit d'amplificateur de signal incluant:
une borne d'entrée (10) pour recevoir un signal d'entrée qui présente un premier niveau de tension;
une première borne (3a);
un moyen de commutation (6) qui est disposé entre la borne d'entrée (10) et la première borne (3a) pour appliquer un signal qui présente le premier niveau de tension (V) sur la première borne (3a) lorsque le moyen de commutation est fermé; un amplificateur tampon (1); et
un moyen de réglage,
**caractérisé en ce que** le moyen de réglage (2, 3) est prévu pour stocker une différence entre le premier niveau de tension et la somme d'une tension de référence (V0) et d'une tension de décalage (ΔV) dudit amplificateur tampon (1) entre la première borne (3a) et une seconde borne (3b), la somme de la tension de référence (V0) et de la tension de décalage (ΔV) étant obtenue en tant que tension de sortie en provenance dudit amplificateur tampon lorsque la tension de référence (V0) est entrée dessus, et pour entrer ensuite une tension (V-ΔV) qui est obtenue en soustrayant la tension de décalage (ΔV) du premier niveau de tension en appliquant la tension de référence sur la seconde borne dans ledit amplificateur tampon (1) de manière à annuler la tension de décalage (ΔV); et
**en ce que**:
le moyen de réglage (2) est muni d'un moyen (4, 14) pour remettre la tension au niveau de ladite première borne (3a) à la tension de référence (V0) avant que le moyen de commutation (6) ne soit fermé.

2. Circuit d'amplificateur de signal selon la revendication 1, dans lequel:
le signal d'entrée est entré de façon synchrone avec une horloge, et la tension de décalage est annulée à chaque horloge par ledit moyen de réglage.

3. Circuit d'amplificateur de signal selon la revendication 1 ou 2, dans lequel:
ledit moyen de réglage est constitué par un premier condenseur (3) ainsi que par des premier, second, quatrième et cinquième éléments de commutation (4, 5, 7, 8);
une borne d'entrée dudit amplificateur tampon (1) est connectée à une borne d'entrée (9) de la tension de référence par l'intermédiaire du premier élément de commutation (4) et à une électrode du premier condenseur qui joue le rôle de première borne (3a) par l'intermédiaire du second élément de commutation (5);
l'autre électrode (3b) du premier condenseur (3) joue le rôle de seconde borne et est connectée à une borne de sortie (1b) dudit amplificateur tampon (1) par l'intermédiaire du quatrième élément de commutation (7) et à la borne d'entrée (9) de la tension de référence par l'intermédiaire du cinquième élément de commutation (8).

4. Circuit d'amplificateur de signal selon la revendication 1 ou 2, dans lequel:
ledit moyen de réglage est constitué par des premier et second condenseurs (3, 16) et par des second et quatrième à septième éléments de commutation;
une borne d'entrée (1a) dudit amplificateur tampon (1) est connectée à une électrode (3a) du premier condenseur qui joue le rôle de première borne (3a) par l'intermédiaire du second élément de commutation (5) et à une borne (V1) d'une tension constante par l'intermédiaire du septième élément de commutation (15) et du second condenseur (16);
ladite une électrode (3a) du premier condenseur (3) est connectée à une borne d'entrée (9) de la tension de référence par l'intermédiaire du sixième élément de commutation (14); et
l'autre électrode (3b) du premier condenseur joue le rôle de seconde borne et est connectée à une borne de sortie (1b) dudit amplificateur tampon (1) par l'intermédiaire du quatrième élément de commutation (7) et à la borne d'entrée (9) de la tension de référence par l'intermédiaire du cinquième élément de commutation (8).

5. Circuit d'amplificateur de signal selon la revendication 1 ou 2, dans lequel:
ledit moyen de réglage est constitué par des premier et troisième condenseurs (3, 17) ainsi que par des premier, quatrième et cinquième éléments de commutation;
une borne d'entrée dudit amplificateur tampon (1) est connectée à une borne d'entrée (9) de la tension de référence par l'intermédiaire du premier élément de commutation (4) et à une électrode (3a) du premier condenseur (3);
ladite une électrode dudit premier condenseur jouant le rôle de première borne (3a);
l'autre électrode du premier condenseur (3) joue le rôle de seconde borne (3b) et est connectée à une borne de sortie (1b) dudit amplificateur tampon par l'intermédiaire du quatrième élément de commutation (7) et à une borne d'entrée (9) de la tension de référence par l'intermédiaire du cinquième élément de commutation (8); et
l'autre électrode (3b) du premier condenseur (3) est connectée à une borne d'une tension constante par l'intermédiaire du troisième condenseur (17).

6. Circuit d'amplificateur de signal selon la revendication 1, 2, 3, 4 ou 5, dans lequel:
un huitième élément de commutation pour appliquer la tension de référence sur une sortie en provenance dudit amplificateur tampon est prévu.

7. Circuit d'amplificateur de signal selon la revendication 1, 2, 3, 4 ou 5, dans lequel:
un neuvième élément de commutation pour séparer ledit amplificateur tampon vis-à-vis d'une charge externe est prévu.

8. Circuit d'amplificateur de signal selon la revendication 3, 4 ou 5, dans lequel:
au moins une entité prise parmi le moyen de commutation et les éléments de commutation est un commutateur à transistor MOS complémentaire.

9. Dispositif d'affichage d'image comprenant:
un affichage (53) qui est constitué par des cellules d'affichage (Cij) qui sont agencées de manière à former une matrice;
un premier circuit de pilotage (51) pour échantillonner un signal vidéo de manière à envoyer une tension qui est obtenue en tant que données par échantillonnage sur une ligne de signal de données (Sj); et
un second circuit de pilotage (52) pour sélectionner une ligne de signal de balayage (Gi) afin d'envoyer des données sur la ligne de signal'de données à chaque cellule d'affichage,
dans lequel ledit premier circuit de pilotage (51) inclut:
un registre à décalage (57);
des circuits de commutation (59) selon le même nombre que le nombre de cellules d'affichage suivant une direction latérale;
des condenseurs d'utilisation en échantillonnage (60) selon le même nombre que le nombre desdits circuits de commutation; et
des circuits d'amplificateur de signal (61) selon le même nombre que le nombre desdits condenseurs d'utilisation en échantillonnage (60),
et ainsi, en utilisation, ledit registre à décalage envoie un signal dans l'ordre dans chaque circuit de commutation de façon synchrone avec un signal d'horloge;
le circuit de commutation est alors établi dans l'état activé lors de la réception d'un signal en provenance dudit registre à décalage;
chaque condenseur d'utilisation en échantillonnage (60) échantillonne un niveau d'un signal vidéo qui est obtenu en tant que données lorsque le circuit de commutation est établi dans l'état activé,
et ainsi, lorsque des données selon le même nombre que le nombre des cellules d'affichage suivant une direction latérale sont contenues dans lesdits condenseurs d'utilisation en échantillonnage, lesdits circuits d'amplificateur de signal reçoivent les données en provenance desdits condenseurs d'utilisation en échantillonnage en une fois et émettent en sortie les données sur la ligne de signal de données, d'où ainsi l'affichage du signal vidéo sur ledit affichage,
dans lequel ledit circuit d'amplificateur de signal inclut:
une borne d'entrée (10) pour recevoir un signal d'entrée qui présente un premier niveau de tension;
une première borne (3a);
un moyen de commutation (6) qui est disposé entre la borne d'entrée (10) et la première borne (3a) pour appliquer un signal qui présente le premier niveau de tension (V) sur la première borne (3a) lorsque le moyen de commutation est fermé;
un amplificateur tampon (1); et
un moyen de réglage,
**caractérisé en ce que** le moyen de réglage (2, 3) est prévu pour stocker une différence entre le premier niveau de tension et la somme d'une tension de référence (V0) et d'une tension de décalage (ΔV) dudit amplificateur tampon (1) entre la première borne (3a) et une seconde borne (3b), la somme de la tension de référence (V0) et de la tension de décalage (ΔV) étant obtenue en tant que tension de sortie en provenance dudit amplificateur tampon lorsque la tension de référence (V0) est entrée dessus, et pour entrer ensuite une tension (V-ΔV) qui est obtenue en soustrayant la tension de décalage (ΔV) du premier niveau de tension (V) en appliquant la tension de référence sur la seconde borne dans ledit amplificateur tampon (1) de manière à annuler la tension de décalage (ΔV); et
**en ce que**:
ladite première borne (3a) à la tension de référence (V0) avant que le moyen de commutation (6) ne soit fermé.

10. Dispositif d'affichage d'image selon la revendication 9, dans lequel:
la tension de décalage est annulée par ledit moyen de réglage à chaque horloge.

11. Dispositif d'affichage d'image selon la revendication 10, dans lequel:
ledit moyen de réglage est constitué par un premier condenseur (3) ainsi que par des premier, second, quatrième et cinquième éléments de commutation (4, 5, 7, 8);
une borne d'entrée (1a) dudit amplificateur tampon (1) est connectée à une borne d'entrée (9) de la tension de référence par l'intermédiaire du premier élément de commutation (4) et à une électrode du premier condenseur qui joue le rôle de première borne (3a) par l'intermédiaire du second élément de commutation (5);
l'autre électrode (3b) du premier condenseur (3) joue le rôle de seconde borne (3b) et est connectée à une borne de sortie (1b) dudit amplificateur tampon (1) par l'intermédiaire du quatrième élément de commutation (7) et à la borne d'entrée (9) de la tension de référence par l'intermédiaire du cinquième élément de commutation (8).

12. Dispositif d'affichage d'image selon la revendication 10, dans lequel:
ledit moyen de réglage est constitué par des premier et second condenseurs (3, 16) et par des second et quatrième à septième éléments de commutation;
une borne d'entrée dudit amplificateur tampon est connectée à une électrode du premier condenseur qui joue le rôle de première borne (3a) par l'intermédiaire du second élément de commutation (5) et à une borne (V1) d'une tension constante par l'intermédiaire du septième élément de commutation (15) et du second condenseur (16);
ladite une électrode (3a) du premier condenseur (3) est connectée à une borne d'entrée (9) d'une tension de référence par l'intermédiaire du sixième élément de commutation (14); et
l'autre électrode (3b) du premier condenseur (3) joue le rôle de seconde borne (3b) et est connectée à une borne de sortie (1b) dudit amplificateur tampon (1) par l'intermédiaire du quatrième élément de commutation (7) et à la borne d'entrée (9) de la tension de référence par l'intermédiaire du cinquième élément de commutation (8).

13. Dispositif d'affichage d'image selon la revendication 10, dans lequel:
ledit moyen de réglage est constitué par des premier et troisième condenseurs (3, 16) ainsi que par des premier, quatrième et cinquième éléments de commutation;
une borne d'entrée (1a) dudit amplificateur tampon (1) est connectée à une borne d'entrée (9) d'une tension de référence par l'intermédiaire du premier élément de commutation (4) et à une électrode (3a) du premier condenseur (3);
ladite une électrode dudit premier condenseur jouant le rôle de première borne (3a);
l'autre électrode (3b) du premier condenseur (3) joue le rôle de seconde borne (3b) et est connectée à une borne de sortie dudit amplificateur tampon par l'intermédiaire du quatrième élément de commutation et à une borne d'entrée de la tension de référence par l'intermédiaire du cinquième élément de commutation; et
l'autre électrode du premier condenseur est connectée à une borne d'une tension constante par l'intermédiaire du troisième condenseur.

14. Dispositif d'affichage d'image selon la revendication 9, 10, 11, 12 ou 13, dans lequel:
un huitième élément de commutation pour appliquer la tension de référence sur une sortie en provenance dudit amplificateur tampon est prévu.

15. Dispositif d'affichage d'image selon la revendication 9, 10, 11, 12 ou 13, dans lequel:
un neuvième élément de commutation pour séparer ledit amplificateur tampon vis-à-vis d'une charge externe est prévu.

16. Dispositif d'affichage d'image selon la revendication 11, 12 ou 13, dans lequel:
au moins une entité prise parmi le moyen de commutation et les éléments de commutation est un commutateur à transistor MOS complémentaire.

17. Dispositif d'affichage d'image selon la revendication 9, dans lequel:
lesdites cellules d'affichage et ledit premier circuit de pilotage sont formés sur le même substrat.

18. Dispositif d'affichage d'image selon la revendication 17, dans lequel:
ledit substrat comprend:
un substrat transparent comportant, formé sur lui, un film mince en silicium amorphe ou un film mince en silicium polycristallin.

19. Dispositif d'affichage d'image selon la revendication 9, 17 ou 18, dans lequel :
un niveau du signal vidéo est consécutif.

20. Dispositif d'affichage d'image selon la revendication 9, 17 ou 18, dans lequel:
le signal vidéo est discret et il présente au moins quatre niveaux.

21. Dispositif d'affichage d'image selon la revendication 9, 17, 18, 19, 20, 21 ou 22 dans lequel:
chaque cellule d'affichage inclut un élément d'affichage à cristaux liquides.

22. Dispositif d'affichage d'image selon la revendication 1, dans lequel ledit moyen de réglage inclut:
un premier condenseur; et
un moyen de commutation qui applique une tension de sortie en provenance dudit amplificateur tampon lorsqu'une tension de référence est entrée dessus sur une première électrode du premier condenseur qui joue le rôle de seconde borne (3b) et ensuite, qui applique la tension de référence sur la première électrode du condenseur et qui connecte la seconde électrode sur ledit amplificateur tampon.

23. Circuit d'amplificateur de signal selon la revendication 1, comprenant en outre un condenseur (60) pour retenir le niveau de tension (V) du signal d'entrée, le condenseur étant connecté à la première borne (3a) par l'intermédiaire du moyen de commutation (6).
